# EUROPEAN PATENT APPLICATION

(11) **EP 4 839 037 A1**
(43) Date of publication of application: **11.11.2026**
(21) Application number: 26176513.5
(22) Date of filing: 05.05.2026
(51) Int. Cl.: H05K 7/20, F24F 13/26, F24F 13/30, F28D 1/02, F24F 1/0053

(54) **DATA CENTER AIRFLOW CLEARANCE SYSTEM AND PROCESS**

(30) Priority: 09.05.2025 US 202563803212 P; 19.05.2025 US 202563808457 P; 26.09.2025 US 202563888830 P
(71) Applicant: Workman, Brian R., Watertown, MA 02472 (US); Olson, Tyler J., Watertown, MA 02472 (US)
(72) Inventor: Workman, Brian R., Watertown, MA 02472 (US); Olson, Tyler J., Watertown, MA 02472 (US)
(74) Representative: Barker Brettell LLP

(57) **Abstract**

Described herein is a ventilation system (2000a) having a plenum system (2012). The plenum system (2012) may include a cooling system (2002a) and a structural base (2010) including the plenum system (2012). The plenum system (2012) may include a plenum (2014), a heat exchanger coil (2016), and one or more inline fans (2018). The one or more inline fans (2018) may be operable to draw an ambient airflow (2024a) into the plenum (2014). The ambient airflow (2024a) may pass around or over the heat exchanger coil (2016) and undergo a temperature change to create a heat exchanger airflow (2026), which may exit the plenum system (2012) as plenum system ambient airflow(2028). The plenum system ambient airflow (2028) may combine with a second ambient airflow in an outdoor environment to create a mixed ambient airflow (2030), which may enter the cooling system (2002a) to allow for improved performance of the cooling system (2002a) compared to performance of the cooling system (2002a) when the ambient airflow (2024a) alone is used.

## Description

### CROSS-REFERENCE TO RELATED APPLICATIONS

This application claims priority to U.S. Provisional Patent Application No. 63/803,212, filed on May 9, 2025, U.S. Provisional Patent Application No. 63/808,457, filed on May 19, 2025, and U.S. Provisional Patent Application No. 63/888,830, filed on September 26, 2025, the entire contents of which are hereby incorporated by reference.

### BACKGROUND

As electrification and carbon neutral initiatives promote the use of clean energy (e.g., electricity generated by the sun, wind, water, and so forth) for heating and cooling needs as an alternative to the use of fossil fuels, the need for energy efficiency solutions have risen for systems that are currently implemented and will be implemented going forward. Thermodynamic heating and cooling systems are utilized to condition clean, comfortable air, for both commercial and residential buildings, and the current process has been understood for quite some time.

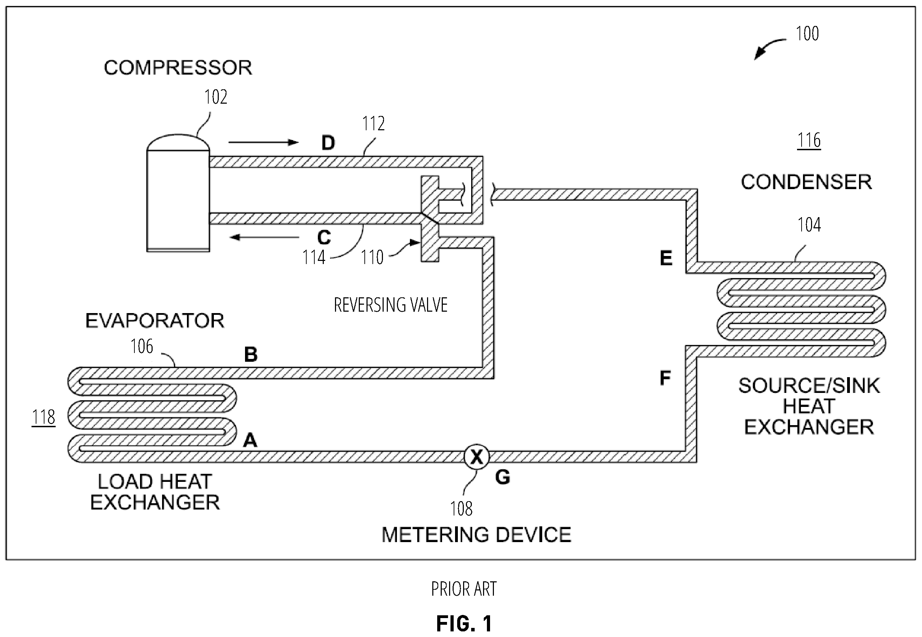

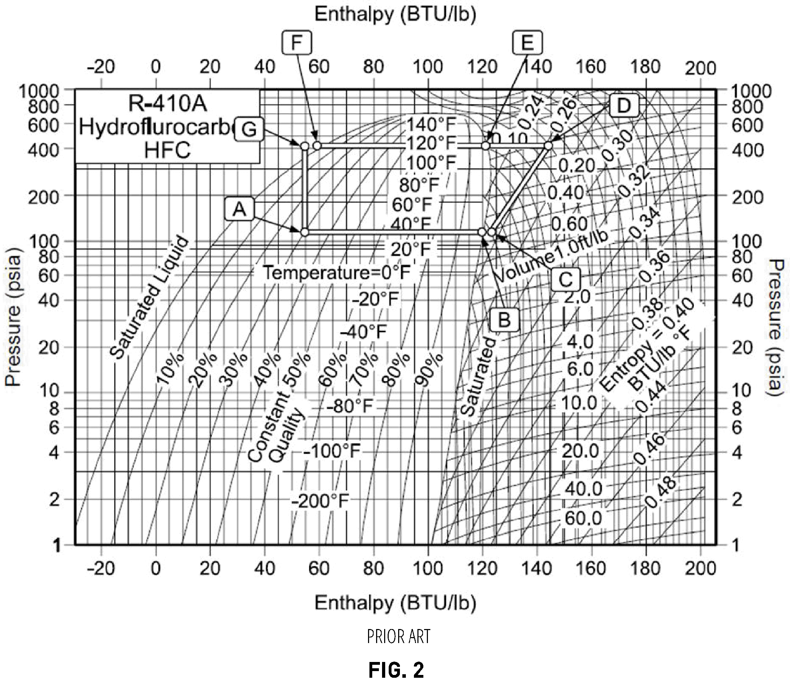

For example, referring to FIG. 1 and FIG. 2 (a pressure-enthalpy refrigeration cycle of a conventional thermodynamic cooling system at 95°F ambient airflow temperature), a conventional thermodynamic cooling (e.g., air-conditioning or refrigeration) system and its associated pressure-enthalpy (PH) refrigeration cycle, respectively, are shown. The conventional thermodynamic cooling ventilation system 100 comprises a compressing unit 102, a condensing unit 104, an evaporating unit 106, and a metering device 108 (e.g., an expansion valve) that are in fluid communication for the purpose of circulating a fluid (e.g., refrigerant) that removes heat from the operating environment. When the heat pump functions as a conventional thermodynamic cooling ventilation system 100, the reversing valve 110 disposed between the compressing unit 102 and the condensing unit 104 and between the compressing unit 102 and the evaporating unit 106 is configured so that fluid exiting a compressor outlet 112 of the compressing unit 102 is channeled (e.g., via the reversing valve 110) to the condensing unit 104 and fluid exiting the evaporating unit 106 is channeled (e.g., via the reversing valve 110) to the compressor inlet 114 of the compressing unit 102. More specifically, when the (e.g., refrigerant) fluid is in a liquid state, the (e.g., refrigerant) fluid absorbs heat, transitioning from the liquid state to a gaseous or vapor state. When the (e.g., refrigerant) fluid is in a gas/vapor state, the (e.g., refrigerant) fluid gives off heat as it transitions from the gaseous state to the liquid state.

For a cooling operation, the (e.g., refrigerant) fluid enters the compressing unit 102 (e.g., via a compressor inlet 114) as a low-pressure, saturated gas/vapor (Point C). The compressing unit 102 compresses the low-pressure, saturated gas/vapor, such that, upon exiting the compressing unit (e.g., via the compressor outlet 112), the (e.g., refrigerant) fluid comprises a high-pressure, saturated gas/vapor (Point D). The high-pressure, saturated gas/vapor travels through the reversing valve 110, entering the condensing unit 104 (Point E).

In the condensing unit 104, the high-pressure, saturated gas/vapor condenses, transitioning from a high-pressure, saturated gas/vapor to a high-pressure mixture having a liquid portion and a gas/vapor portion to a saturated, high-pressure liquid. The condensation process (Point E to Point F) gives off heat to the (e.g., the exterior or outdoor) environment 116. The saturated, high pressure, condensed liquid exiting the condensing unit 104 (Point F) then travels to the metering device 108 (e.g., expansion valve) (Point G).

The metering device 108 (e.g., expansion valve) restricts the flow of the fluid, lowering the pressure, transitioning the saturated, high pressure, condensed liquid into a low-pressure mixture having a liquid portion and a gas/vapor portion (Point A). The low-pressure mixture having a liquid portion and a gas/vapor portion enters the evaporating unit 106 (Point A). The evaporating unit 106 (Point A) causes the low-pressure mixture having a liquid portion and a gas/vapor portion to transition into a low-pressure saturated gas/vapor (Point B). The transition (Point A to Point B) absorbs heat from the (e.g., interior, or indoor) environment 118. The heated, low-pressure saturated gas/vapor travels to the compressor inlet 114 (Point C) of the compressing unit 102 and the cooling cycle is repeated.

Pressure, temperature, and enthalpy values for a typical cooling cycle are shown in TABLE I. More specifically, referring to TABLE I and FIG. B, between Points A and B, a low-temperature, low-pressure fluid (e.g., a mixture of liquid and gas/vapor) from the metering device 108 enters the evaporating unit 106, causing an increase in enthalpy, which cools the (e.g., interior, or indoor) environment 118. Between Points B and C, the low-temperature, low-pressure fluid (e.g., gas/vapor) becomes a saturated gas/vapor as it travels to the compressing unit 102, causing slight increases to the temperature and enthalpy.

| TABLE I. CONVENTIONAL THERMODYNAMIC COOLING OPERATION PERFORMANCE | | | |
|---|---|---|---|
| | PRESSURE (PSIA) | TEMP (DEG F) | ENTHALPY (BTU/lb) |
| A | 120 | 34 | 52.4 |
| B | 120 | 34 | 121.2 |
| C | 120 | 40 | 122.8 |
| D | 600 | 114 | 144 |
| E | 600 | 114 | 122.5 |
| F | 600 | 114 | 58.8 |
| G | 600 | 600 | 52.4 |

Between Points C and D, the low-temperature, low-pressure fluid (e.g., saturated gas/vapor) enters the compressing unit 102, where the fluid is compressed to provide a high-temperature, high-pressure fluid (e.g., saturated gas/vapor). Between Points D and E, the high-temperature, high-pressure fluid (e.g., saturated gas/vapor) travels to the condensing unit 104, causing a slight decrease in enthalpy. Between Points E and F, the high-temperature, high-pressure fluid (e.g., saturated gas/vapor) transitions into a high-temperature, high-pressure fluid (e.g., saturated liquid), resulting in a more significant decrease in enthalpy. Heat from the condensing unit 104 is exchanged into the (e.g., exterior, or outdoor) environment 116.

Between Points F and G, the temperature and enthalpy of the high-temperature, high-pressure fluid (e.g., saturated liquid) decreases slightly as the saturated liquid enters the metering device (e.g., expansion valve) 108. Between Points G and A, the high-temperature, high-pressure fluid (e.g., saturated liquid) transitions to a low-temperature, low-pressure fluid (e.g., liquid and gas/vapor mixture) that has approximately the same enthalpy. The cycle repeats at this point.

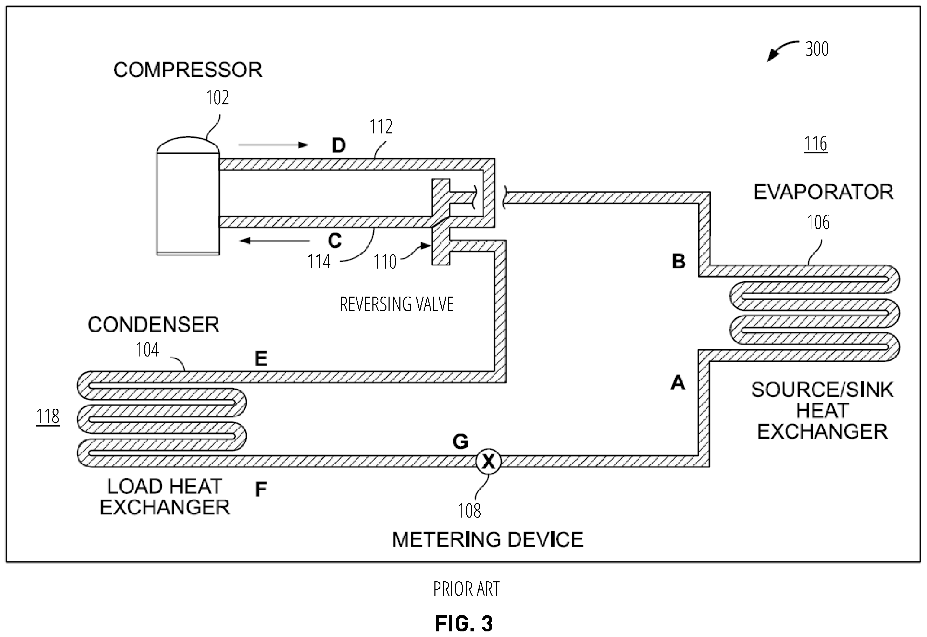

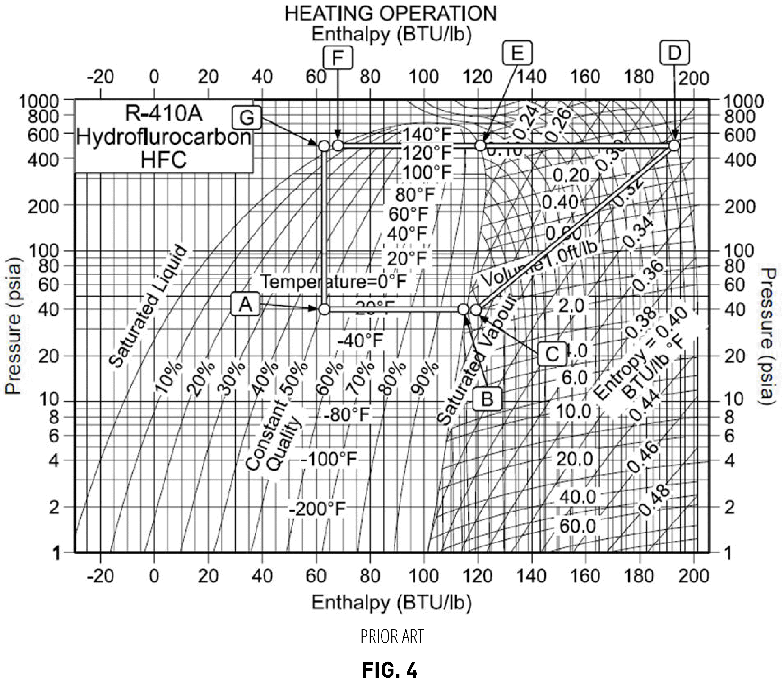

Referring to FIG. 3 and FIG. 4 (a pressure-enthalpy refrigeration cycle of a conventional thermodynamic heating ventilation system at 0°F ambient airflow temperature), a conventional thermodynamic heating ventilation system and its associated pressure-enthalpy (PH) refrigeration cycle, respectively, are shown. In some embodiments, the conventional thermodynamic heating ventilation system 200 also comprises a compressing unit 102, a condensing unit 104, an evaporating unit 106, and a metering device 108 (e.g., an expansion valve) that are in fluid communication for the purpose of circulating a (e.g., refrigerant) fluid that adds heat into the operating environment. Advantageously, when the heat pump functions as a conventional thermodynamic heating ventilation system 200, the reversing valve 110 disposed between the compressing unit 102 and the condensing unit 104 and between the compressing unit 102 and the evaporating unit 106 is configured so that fluid exiting the compressor outlet 112 of the compressing unit 102 is channeled (e.g., via the reversing valve 110) to the condensing unit 104 and fluid exiting the evaporating unit 106 is channeled (e.g., via the reversing valve 110) to the compressor inlet 114 of the compressing unit 102.

For a heating operation, the (e.g., refrigerant) fluid enters the compressing unit 102 (e.g., via a compressor inlet 114) as a low-pressure, low-temperature saturated gas/vapor. The compressing unit 102 compresses the (e.g., refrigerant) fluid, causing the fluid to transition from a low-pressure, low-temperature saturated gas/vapor into a high-pressure, high-temperature (e.g., superheated) saturated gas/vapor. Condensation of the (e.g., refrigerant) fluid gives off heat to the interior or indoor environment 118. More specifically, the entering (e.g., refrigerant) fluid transitions from a high-pressure, high-temperature, saturated gas/vapor into a saturated liquid.

The (e.g., refrigerant) fluid then travels to the metering device 108 (e.g., expansion valve). The metering device 108 restricts the flow of the (e.g., refrigerant) fluid, lowering the pressure and temperature. The low-temperature, low-pressure fluid (e.g., saturated liquid) then enters the evaporating unit 106, where it absorbs heat from the (e.g., exterior, or outdoor) environment 116, changing the fluid from a low-temperature, low-pressure liquid to a low-temperature, low-pressure gas/vapor. The (e.g., refrigerant) fluid then travels to the compressor inlet 114 of the compressing unit 102 and the heating cycle is repeated.

Pressure, temperature, and enthalpy values for a typical heating cycle are shown in TABLE II. More specifically, referring to TABLE II and FIG. 17, between Points A and B, a low-temperature, low-pressure fluid (e.g., a mixture of liquid and gas/vapor) from the metering device 108 (at Point G) enters the evaporating unit 106, causing an increase in enthalpy, which draws heat from the (e.g., exterior, or outdoor) environment 116. Between Points B and C, the low-temperature, low-pressure mixture of liquid and gas/vapor becomes a low-temperature, low-pressure saturated gas/vapor as it travels through the reversing valve 110 to the compressing unit 102, causing slight increases to the temperature and enthalpy.

| TABLE II. CONVENTIONAL THERMODYNAMIC HEATING OPERATION PERFORMANCE | | | |
|---|---|---|---|
| | PRESSURE (PSIA) | TEMP (DEG F) | ENTHALPY (BTU/lb) |
| A | 40 | -21 | 64.2 |
| B | 40 | -21 | 116.5 |
| C | 40 | -15 | 117.8 |
| D | 500 | 131 | 194 |
| E | 500 | 131 | 121 |
| F | 500 | 131 | 67.4 |
| G | 500 | 125 | 64.2 |

Between Points C and D, the low-temperature, low-pressure fluid (e.g., saturated gas/vapor) enters the compressing unit 102, where the fluid is compressed to provide a high-temperature, high-pressure (e.g., superheated) fluid (e.g., saturated gas/vapor). Between Points D and E, the high-temperature, high-pressure fluid (e.g., saturated gas/vapor) travels via the reversing valve 110 to the condensing unit 104, causing a slight decrease in enthalpy. Between Points E and F, the high-temperature, high-pressure fluid (e.g., saturated gas/vapor) transitions to a high-temperature, high-pressure fluid (e.g., saturated liquid), resulting in a more significant decrease in enthalpy. Heat from the condensing unit 10 is exchanged into the (e.g., interior, or indoor) environment 118.

Between Points F and G, the temperature and enthalpy of the high-temperature, high-pressure fluid (e.g., saturated liquid) decreases slightly as the saturated liquid enters the metering device 108 (e.g., expansion valve). Between Points G and A, the high-temperature, high-pressure fluid (e.g., saturated liquid) transitions to a low-temperature, low-pressure fluid (e.g., mixture of liquid and gas/vapor) that has approximately the same enthalpy. The cycle repeats at this point.

Problematically, during the heating operation, there is a larger pressure and temperature change (i.e., delta) between the high side of the refrigeration cycle and the low side of the refrigeration cycle. Indeed, the suction temperature proximate the compressor inlet 114 of the compressing unit 102 becomes more of a limiting factor as the ambient temperature in the (e.g., exterior, or outdoor) environment 116 decreases further (e.g., to sub-zero temperatures), affecting the ability of the conventional thermodynamic heating ventilation system 200 to operate effectively.

**TABLE III. CONVENTIONAL THERMODYNAMIC HEATING SYSTEM CONDENSER CAPACITY AND EFFICIENCY**

| | | |
|---|---|---|
| Condenser Capacity | 186100 | BTUH |
| Efficiency | 1.78 | COP |

Referring to TABLE III, which illustrates an example at 0 degrees ambient for heating mode, the conventional thermodynamic heating ventilation system condenser capacity is 186,100 BTUH and the coefficient of performance (COP) efficiency is 1.78. COP is a dimensionless value that measures the electrical efficiency of heating and cooling systems.

In current thermodynamic cooling systems, when the high-pressure, saturated gas/vapor condenses in the condensing unit 104 (Point E to Point F), the process gives off heat to the (e.g., the exterior or outdoor) environment 116. In current thermodynamic heating systems, when the low-pressure, low-temperature liquid evaporates in the evaporating unit 106, the process absorbs heat (thereby giving off cooling) from the (e.g., the exterior or outdoor) environment 116.

Proper clearance around air-cooled cooling systems is helpful for maintaining efficient operation. When cooling systems are installed in close proximity, especially in data centers, hot discharged airflow from one system can recirculate into the intake of another, significantly raising inlet temperatures and undermining heat rejection efficiency.

There remains a need for improved cooling systems that can operate efficiently in environments where space constraints lead to air recirculation, where ambient temperatures are elevated due to dense equipment layouts, or where ambient temperatures are too cold for optimal operation.

### SUMMARY

In one aspect, a ventilation system having a plenum system is provided. The ventilation system includes a cooling system. The cooling system includes a condenser, condenser coils, and a source/sink fan. The ventilation system includes a structural base including the plenum system. The plenum system includes a plenum, a heat exchanger coil, and one or more inline fans. The inline fans are operable to draw an ambient airflow into the plenum. The ambient airflow passes around or over the heat exchanger coil and undergoes a temperature change to create heat exchanger airflow. The heat exchanger airflow exits the plenum system as plenum system ambient airflow. The plenum system ambient airflow combines with a second ambient airflow in an outdoor environment to create a mixed ambient airflow. The mixed ambient airflow enters the cooling system to allow for improved performance of the cooling system compared to performance of the cooling system when the ambient airflow alone is used.

In another aspect, a method of using a ventilation system having a plenum system is provided. The method includes enabling ambient airflow to enter into the plenum system including one or more plenums, passing the ambient airflow through a plenum of the plenum system by inline fans, passing the ambient airflow around or over a heat exchanger coil, thereby creating heat exchanger airflow, exiting the heat exchanger airflow from the plenum system as plenum system ambient airflow, enabling the plenum system ambient airflow to combine with a second ambient airflow in an outdoor environment to create mixed ambient airflow, and pulling the mixed ambient airflow into a cooling system. The mixed ambient airflow allows for improved performance of the cooling system compared to performance of the cooling system when the ambient airflow alone is used.

### BRIEF DESCRIPTION OF THE DRAWINGS

FIG. 1 illustrates a conventional thermodynamic cooling system.
FIG. 2 illustrates an exemplary pressure-enthalpy refrigeration cycle of a conventional thermodynamic cooling system at 95°F ambient airflow temperature.
FIG. 3 illustrates a conventional thermodynamic heating ventilation system.
FIG. 4 illustrates an exemplary pressure-enthalpy refrigeration cycle of a conventional thermodynamic heating ventilation system at 0°F ambient airflow temperature.
FIG. 5A illustrates a side view of a conventional thermodynamic cooling system.
FIG. 5B illustrates a side view of a conventional thermodynamic cooling system.
FIG. 6 illustrates a top-down view of an exemplary layout of a data center chiller plant.
FIG. 7A illustrates a side view of an exemplary ventilation system in accordance with an embodiment of the disclosed subject matter.
FIG. 7B illustrates a side view of an exemplary ventilation system in accordance with an embodiment of the disclosed subject matter.
FIG. 7C illustrates a processing system in accordance with an embodiment of the disclosed subject matter.
FIG. 7D illustrates a side view of an exemplary ventilation system in accordance with an embodiment of the disclosed subject matter.
FIG. 7E illustrates a side view of an exemplary ventilation system in accordance with an embodiment of the disclosed subject matter.
FIG. 7F illustrates a side view of an exemplary ventilation system in accordance with an embodiment of the disclosed subject matter.
FIG. 7G illustrates a side view of an exemplary ventilation system in accordance with an embodiment of the disclosed subject matter.
FIG. 7H illustrates a side view of an exemplary waterside diagram of a ventilation system in accordance with an embodiment of the disclosed subject matter.
FIG. 7I illustrates a side view of an exemplary ventilation system in accordance with an embodiment of the disclosed subject matter.
FIG. 7J illustrates a side view of an exemplary waterside diagram of a ventilation system in accordance with an embodiment of the disclosed subject matter.
FIG. 8A illustrates a top-down view of an exemplary layout of a data center chiller plant in accordance with an embodiment of the disclosed subject matter.
FIG. 8B illustrates a top-down view of a portion of the exemplary layout of the data center chiller plant in accordance with an embodiment of the disclosed subject matter.
FIG. 8C illustrates a side view of the exemplary layout of the data center chiller plant in accordance with an embodiment of the disclosed subject matter.
FIG. 8D illustrates a side view of a portion of the exemplary layout of the data center chiller plant in accordance with an embodiment of the disclosed subject matter.
FIG. 9A illustrates a table comparing performances of two cooling systems at ambient temperatures of 103°F and 120°F, respectively, in accordance with an embodiment of the disclosed subject matter.
FIG. 9B illustrates a table comparing aggregate performances of twenty cooling systems at ambient temperatures of 103°F and 120°F, respectively, in accordance with an embodiment of the disclosed subject matter.
FIG. 9C illustrates a side view of an exemplary ventilation system that is improved by embodiments of the disclosed subject matter.
FIG. 10A illustrates a table displaying energy consumption of a cooling system, an inline fan, and a cooling system and inline fan combined in accordance with an embodiment of the disclosed subject matter.
FIG. 10B illustrates a table comparing input energy consumption and total energy consumption of a standard cooling system and a cooling system utilizing a plenum system, with both systems operating at an ambient temperature of 120°F, in accordance with an embodiment of the disclosed subject matter.
FIG. 11 illustrates an example method for an exemplary ventilation system in accordance with an embodiment of the disclosed subject matter.
FIG. 12 illustrates a side view and top views of an straightener attachment in accordance with an embodiment of the disclosed subject matter.
FIG. 13A illustrates a side view and a top view of an exemplary venturi attachment in accordance with an embodiment of the disclosed subject matter.
FIG. 13B illustrates side views and a top view of an exemplary venturi attachment in accordance with an embodiment of the disclosed subject matter.
FIG. 14 illustrates a side view of an exemplary ventilation system in accordance with an embodiment of the disclosed subject matter.
FIG. 15 illustrates a side view of an exemplary attachment assembly in accordance with an embodiment of the disclosed subject matter.

### DETAILED DESCRIPTION

A ventilation system having a plenum system for improved performance of a cooling system is described herein. In some embodiments, the ventilation system includes the cooling system. The cooling system may include a condenser, condenser coils, and a source/sink fan. The ventilation system may include a structural base including the plenum system. The plenum system may include a plenum, a heat exchanger coil, and one or more inline fans operable to draw an ambient airflow into the plenum. The ambient airflow may pass around or over the heat exchanger coil and undergo a temperature change to create heat exchanger airflow. The heat exchanger airflow may exit the plenum system as plenum system ambient airflow. The plenum system ambient airflow may combine with a second ambient airflow in an outdoor environment to create a mixed ambient airflow. The mixed ambient airflow may enter the cooling system to allow for improved performance of the cooling system compared to performance of the cooling system when the ambient airflow alone is used.

Also described herein is a method of using a ventilation system having a plenum system for improved performance of a cooling system. The method may include enabling an ambient airflow to enter into the plenum system including one or more plenums. The method may include passing the ambient airflow through a plenum of the plenum system by inline fans. The method may include passing the ambient airflow around or over a heat exchanger coil, thereby creating heat exchanger airflow. The method may include exiting the heat exchanger airflow from the plenum system as plenum system ambient airflow. The method may include enabling the plenum system ambient airflow to combine with a second ambient airflow in an outdoor environment to create mixed ambient airflow. The method may include pulling the mixed ambient airflow into a cooling system. The mixed ambient airflow may allow for improved performance of the cooling system compared to performance of the cooling system when the ambient airflow alone is used.

The plenum system may be fabricated from a multitude of different materials. The plenum system may include durable and/or rigid materials such as galvanized steel or aluminum, sheet metal, PVC, plastics, and/or other materials. In some embodiments, the plenum system includes fabric, flexible material, and/or soft material as ducting, which may allow for lightweight and/or quick installation.

In some embodiments, the plenum system is located and sized to fit the specific cooling system and/or heat pump requirements of the ventilation system for the respective type of building (e.g., brick exterior, glass exterior, etc.) and building usage or specific application (e.g., data center, office building, and the like). The plenum system may be positioned in an indoor environment, in an outdoor environment, or partially between the two. The plenum system may be partially or fully enclosed within a building, or the plenum system may not be enclosed within a building.

The plenum system may be configured with one or more duct connections depending on the specific application. For example, the duct connections may be configured to be equipped with dampers or louvers to regulate airflow and prevent backflow of air when a thermodynamic system (e.g., a cooling system) is not in operation. In addition, or alternatively, the plenum system may be equipped with a filter upstream at the duct connections to aid in filtering any items not intended to enter the cooling system. In some embodiments, the plenum system includes one or more duct systems (e.g., soft material duct systems) to displace discharged and/or recirculated airflow that enters the plenum system.

In some embodiments, the plenum system may be configured with access points, such as removable panels or access doors, to facilitate inspection, cleaning, and maintenance of the ducts, duct connections, and associated components.

The plenum system may be configured to isolate rooftop equipment from the building structure, thereby preventing the transfer of vibrations and noise caused by operation of the equipment. Vibration transfer prevention helps to minimize disturbance to building occupants and also reduces the risk of structural damage. The transfer of vibrations and noise may be prevented by using vibration isolation elements that are comprised of materials that dampen vibrations, such as rubber, neoprene, spring isolators, or the like.

In some embodiments, the plenum system is equipped with a heat trace system or snow melt system to effectively manage and prevent snow or ice buildup. The heat trace system may, for example, include electric heaters or is fed from the building hot water supply system with coils strategically located within plenum system, or the like. The plenum system may be equipped with a drain to ensure proper drainage.

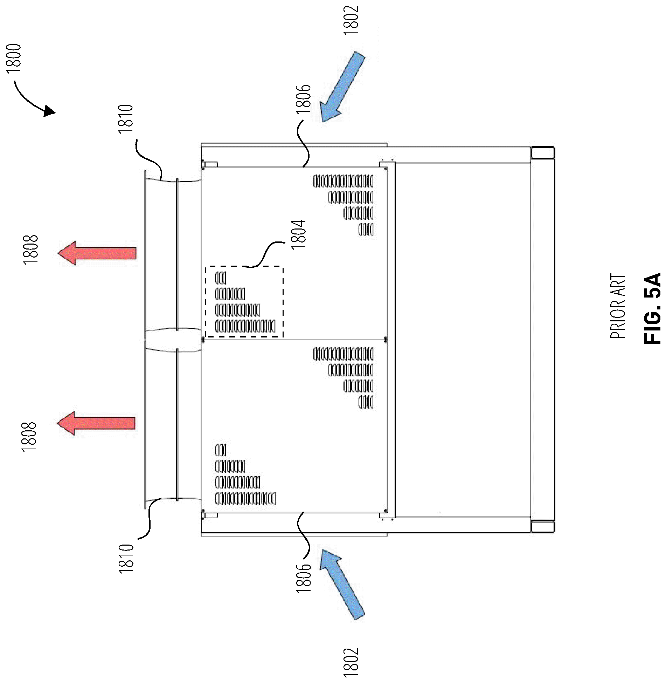

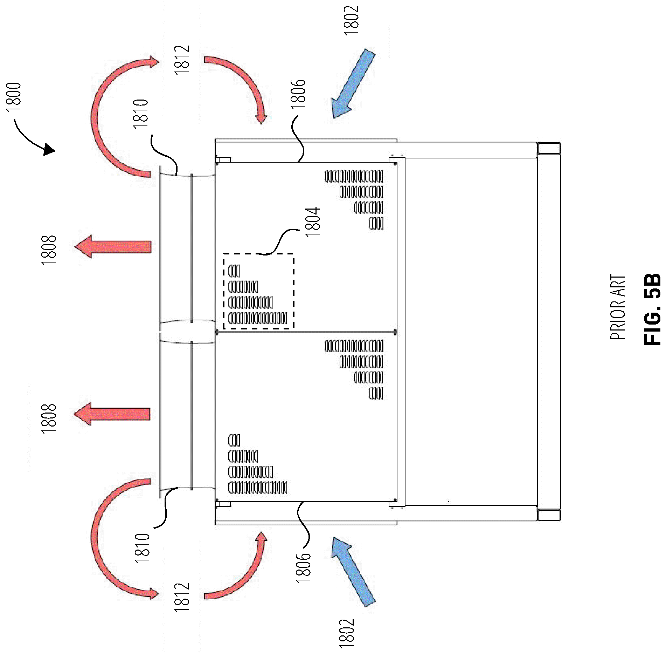

Referring to prior art FIGs. 5A and 5B, a side view of a conventional thermodynamic cooling system 1800 is shown. The cooling system 1800 relies on ambient airflow 1802 to cool refrigerant within the cooling system 1800 via condenser coils within a condenser 1806 of the cooling system 1800. The ambient airflow 1802 may enter the cooling system 1800 through vent louvers 1804 on a wall or door of the cooling system 1800. In order for refrigerant to be cooled effectively, the cooling system 1800 with sufficient clearances draws in fresh, cool, ambient airflow 1802 and expels hot, discharged airflow 1808 from source/sink fans 1810 without obstruction. When clearance around the cooling system 1800 is insufficient, especially in areas surrounding an inlet of the cool ambient airflow 1802 and an outlet of the hot, discharged airflow 1808, the discharged airflow 1808 from the cooling system 1800 can recirculate back into an inlet as recirculated discharged airflow 1812. This process, known as air recirculation, significantly raises a temperature of the ambient airflow 1802 entering the cooling system 1800, which undermines the cooling system's 1800 ability to efficiently reject heat.

As the ambient airflow 1802 becomes warmer due to the recirculated discharged airflow 1812, condenser pressure increases. An increase of condenser pressure not only reduces cooling capacity of the cooling system 1800, but also forces the cooling system 1800 to consume more energy and wears down components of the cooling system 1800. These factors can lead to a variety of operational issues including high head pressure, compressor overheating, and/or shutdown of the cooling system 1800 entirely. In severe cases, repeated thermal stress can cause premature failure of compressors, fan motors, and/or condenser coils.

To avoid these issues, proper clearance around each cooling system 1800 is preferably maintained. Though exact requirements vary by manufacturer, general industry guidelines recommend a clearance of at least six feet on all sides of each cooling system 1800. When multiple cooling systems 1800 (which may include chillers) are installed in proximity to each other, however, greater spacing is needed between them to prevent cross-contamination of the hot, discharged airflow 1808 from their respective condensers. Obstructions such as walls, barriers, or other equipment can also compromise the ambient airflow 1802 into the cooling systems 1800. Providing adequate space around the cooling systems 1800 aids in ensuring reliable, efficient, long-term operation.

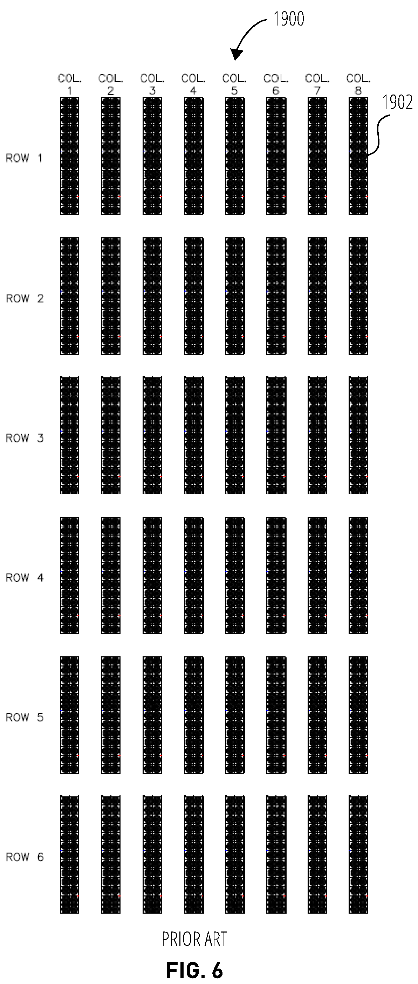

Data centers generate a tremendous amount of heat due to a high density of servers and computing equipment running at all hours of the day. To maintain optimal performance and prevent hardware failures, the generated heat must be efficiently removed, which makes cooling an important infrastructure component in any data center. A common solution for cooling a data center is through the use of cooling systems, which may include air-cooled chillers, which are often deployed in large numbers to handle the substantial cooling load. Referring to FIG. 6, a top-down view of an exemplary layout of a data center chiller plant 1900, is shown. A chiller plant may include a plurality of ventilation systems integrated to form a larger cooling ventilation infrastructure. The distinction between individual ventilation systems and a chiller plant may depend on a scale and application-when ventilation systems are combined for a specific facility (e.g., a data center), they may collectively constitute a chiller plant designed for that particular use case. The exemplary chiller plant 1900 has forty-eight cooling systems 1902 arranged in six rows and eight columns. The cooling systems 1902 in the interior rows and columns will have more difficulty receiving ambient airflow as opposed to the cooling systems 1902 in the outer rows and columns.

Because of the scale of modern data centers, the multiple air-cooled cooling systems 1902 are commonly installed in close proximity, often grouped together on rooftops or in dedicated outdoor spaces. This layout introduces unique challenges related to airflow management. When several cooling systems 1902 are operating in the same area, all of the cooling systems 1902 rely on surrounding ambient airflow to reject heat. If proper clearances are not maintained between the cooling systems 1902, the risk of recirculation-where hot, discharged airflow from one cooling systems 1902 is drawn into an intake of another-significantly increases.

This shared airflow environment demands careful planning of cooling system 1902 placement and orientation. The goal is to ensure that each cooling system 1902 receives a consistent supply of fresh, ambient airflow while effectively expelling heated, discharged airflow away from the other cooling systems 1902. Inadequate spacing or poor ambient airflow management can lead to increased condenser inlet temperatures, reduced efficiency, and high-pressure failure of the cooling systems, all of which can compromise cooling capacity of one or more cooling systems. This is especially important in data centers, where even a brief loss of cooling can lead to overheating, server downtime, and potential data loss. Therefore, proper clearance and strategic airflow design is essential not just for individual cooling systems performance, but for the reliability and uptime of the entire data center.

In data centers, where space is at a premium, air-cooled cooling systems 1902 are often installed in close proximity. The dense layout of the chiller plant 1900 leads to elevated airflow temperatures between cooling systems 1902, with recirculated airflow sometimes reaching as high as 165°F-well above the temperature of ambient airflow. Such recirculation severely impairs the performance and efficiency of air-cooled systems, making it difficult for them to reject heat properly.

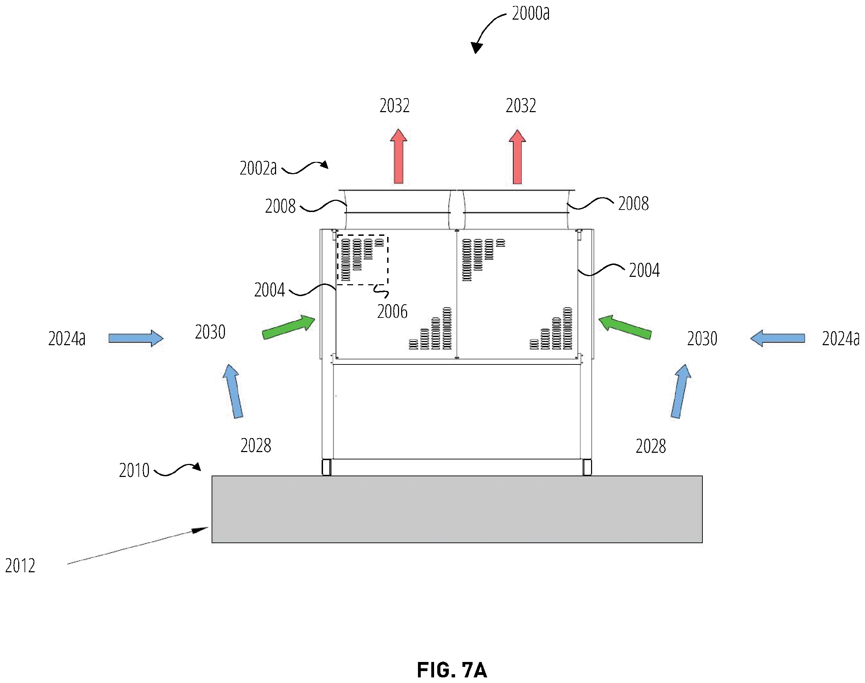

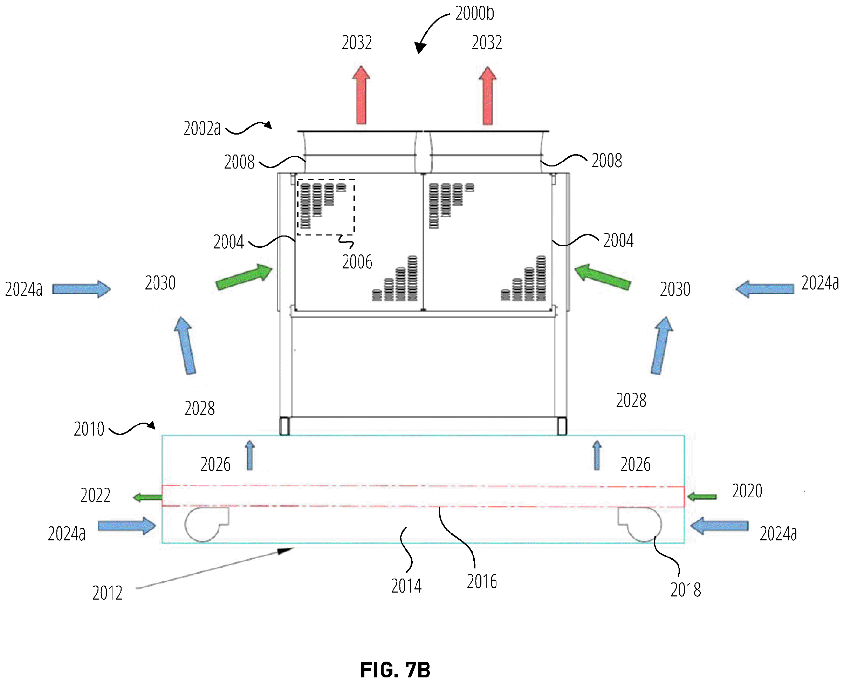

FIG. 7A and FIG. 7B illustrate side views of exemplary ventilation systems 2000a and 2000b, respectively, in accordance with an embodiment of the disclosed subject matter. The ventilation systems 2000a, 2000b may include a cooling system 2002a. The cooling system 2002a may include one or more condensers 2004, one or more vent louvers 2006, and/or one or more source/sink fans 2008. In some embodiments, the cooling system 2002a includes an air source heat pump. The structural base 2010 may include a plenum system 2012. The plenum system 2012 may include a plenum 2014, a heat exchanger coil 2016, one or more inline fans 2018, heat exchanger coil cold fluid 2020, and heat exchanger coil warm fluid 2022. The ventilation systems 2000a, 2000b may also include ambient airflow 2024a, heat exchanger airflow 2026, plenum system ambient airflow 2028, mixed ambient airflow 2030, and/or discharged airflow 2032.

Building on the ventilation systems as described previously, the ventilation systems 2000a, 2000b improve energy efficiency, ensure more reliable equipment operation, and enhance overall unit stability by supplying the condenser coils 2002a with the cooler, mixed ambient airflow 2030 than what is typically available in high-density installations, thereby enhancing a heat exchange. The ventilation systems 2000a, 2000b address issues of prior ventilation systems by providing a cooling system 2002a that minimizes intake of recirculated air and instead utilizes the plenum system ambient airflow 2028.

In some embodiments, the cooling system 2002a includes one or more chillers or refrigeration units. The cooling system 2002a may receive the plenum system ambient airflow 2028 from the plenum system 2012 through the vent louvers 2006 and/or condenser coils of the cooling system 2002a. The cooling system 2002a may be used in data centers or a similar application which requires cooling within an enclosed space or building.

The structural base 2010 may include materials such as cement, concrete, metal, or any other type of material. The structural base 2010 may be positioned adjacent to (e.g., beneath) the cooling system 2002a. In some embodiments, the structural base 2010 includes the plenum system 2012. The structural base 2010 and/or the plenum system 2012 may be developed for permanent and/or temporary installations. The structural base 2010 and/or the plenum system 2012 may be added to new construction and/or retrofit applications. In examples, the plenum system 2012 may be positioned within the structural base 2010 (e.g., the structural base 2010 encloses the plenum system 2012). The plenum system 2012 may include one or more plenums 2014. The plenum system 2012 may span a length of the cooling system 2002a. In some embodiments, the plenum system 2012 spans an entire length of the cooling system 2002a. As shown in the ventilation system 2000b, a first end of the plenum 2014 and/or a second end of the plenum 2014 of the plenum system 2012 may include the one or more inline fans 2018 are operable to draw the ambient airflow 2024a into the plenum 2014, which may be pressurized. The ambient airflow 2024a may be sourced from an outdoor environment and/or be outside of a building. In some embodiments, a ventilation system does not include the one or more inline fans 2018 and the plenum system 2012 instead operates on negative pressure from the cooling system 2002a.

In some embodiments, the plenum system 2012 includes a geothermal component. A geothermal component may support and optimize cooling. A geothermal component can use fluid (e.g., water e.g., from the ground, or air) and circulate fluid through coils embedded in a geothermal component, allowing for the ambient airflow 2024a to be cooled. Geothermal component coils may include air-to-refrigerant coils, air-to-water coils, steam coils, fluid-to-fluid coils, evaporator coils, condenser coils, shell- and-tube coils, tube-in-tube coils, energy recovery coils, heat reclaim coils, condenser reheat coils, counterflow coils, parallel flow coils, crossflow foils, single-pass coils, multiple-pass coils, interlace coils, hydronic coils, refrigerant coils, low ambient coils, or any other type of coil. A geothermal component may vary based on site-specific conditions and available resources, with various exchange methods being suitable depending on location. A geothermal component may operate in an energy-efficient manner, particularly during peak cooling hours when demand is highest. During off-peak times, a geoexchange field may dissipate stored thermal energy. When properly managed, a geoexchange field can recover to its natural temperature through groundwater movement and ground heat exchange with the surrounding earth, ensuring long-term efficiency and continuous operation without thermal imbalance. A geothermal component may include the heat exchanger coil 2016. The ambient airflow 2024a may pass around or over the heat exchanger coil 2016, which receives the heat exchanger coil cold fluid 2020. The heat exchanger coil 2016 may be positioned parallel to a length of the plenum system 2012. The ambient airflow 2024a may pass around or over the heat exchanger coil 2016, undergoing a temperature change and creating the heat exchanger airflow 2026 cooled by the heat exchanger coil 2016, which results in the heat exchanger coil 2016 outputting the heat exchanger coil warm fluid 2022. The structural base 2010 may include one or more geothermal components in addition to or alternatively to the heat exchanger coil 2016 to lower a temperature of the heat exchanger airflow 2026 before it exits the structural base 2010.

The heat exchanger airflow 2026 may exit the plenum system 2012 as the plenum system ambient airflow 2028. In some embodiments, the heat exchanger airflow 2026 exits the plenum system 2012 as the plenum system ambient airflow 2028 into an outdoor environment. The plenum system 2012 may include an opening to allow the plenum system ambient airflow 2028 to flow from the plenum system 2012. An opening may enable the plenum system ambient airflow 2028 to exit the plenum system 2012 into an outdoor environment. An opening of the plenum system 2012 may be adjacent to the cooling system 2002a (e.g., within about 8 to 10 feet). In some embodiments, an opening spans a length of the cooling system 2002a, which may be an entire length of the cooling system 2002a. In some embodiments, an opening is a grating (e.g., an open grating). A pattern of a grating may be linear or a grid.

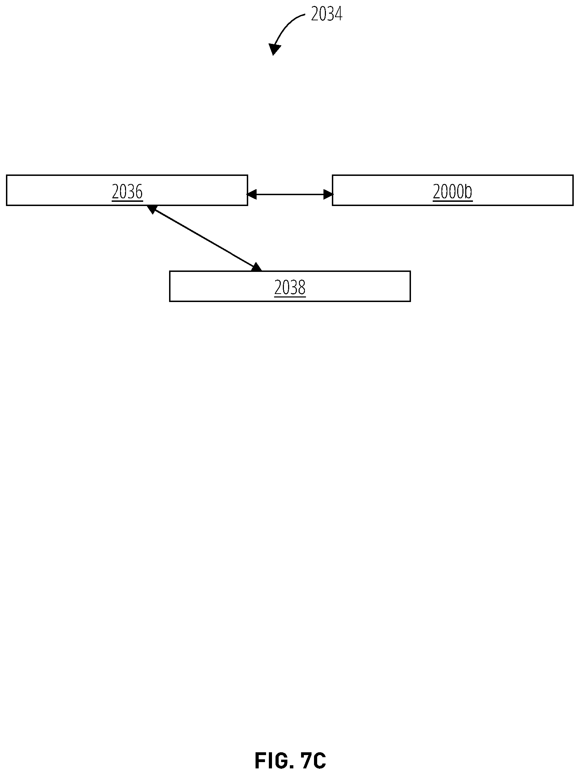

An opening may include one or more control mechanisms to isolate streams of the plenum system ambient airflow 2028. One or more control mechanisms may include dampers. In some embodiments, one or more control mechanisms are controlled using a processor (such as the processor 2036 as shown in FIG. 7C, which depicts a processing system 2034 including the processor 2036, the ventilation system 2000b, and a memory 2038 utilized by the processor 2036) based on a temperature of the ambient airflow 2024a entering the one or more inline fans 2018 and/or a temperature of the mixed ambient airflow 2030 entering cooling system 2002a (e.g., through the vent louvers 2006 and/or condenser coils).

In some embodiments, the plenum system 2012 includes one or more perimeter discharge nozzles configured to direct at least a portion of the plenum system ambient airflow 2028 upward and/or outward along one or more exterior surfaces of the cooling system 2002a of FIGs. 7A and 7B, for example. Perimeter discharge nozzles may form an air curtain that inhibits the discharged airflow 2032 from migrating laterally and/or downward to recirculate toward an inlet plane of the condenser 2004. An air curtain may be continuous or segmented, and/or may be formed through one or more linear slot nozzles, round nozzles, diffuser arrays, and/or adjustable louvers. An air curtain may create a controlled positive-pressure sheath surrounding the condenser 2004 footprint, which may reduce entrainment of the discharged airflow 2032 into an inlet region of the condenser 2004.

The plenum system ambient airflow 2028 may cool the cooling system 2002a. At least a portion of the plenum system ambient airflow 2028 may combine with the ambient airflow 2024a to create the mixed ambient airflow 2030. At least a portion of the plenum system ambient airflow 2028 may combine with the ambient airflow 2024a in an outdoor environment to create the mixed ambient airflow 2030. As shown in FIG. 7B, the ambient airflow 2024a that mixes with the plenum system ambient airflow 2028 may be a "second" ambient airflow 2024a from the same source (e.g., an outdoor environment) as the ambient airflow 2024a that initially enters the plenum system 2012 (e.g., the ambient airflow 2024a may include a first ambient airflow which enters the plenum system 2012 and a second ambient airflow that mixes with the plenum system ambient airflow 2028 to create the mixed ambient airflow 2030). A temperature of the mixed ambient airflow 2030 may be lower than a temperature of the ambient airflow 2024a due to the addition of the plenum system ambient airflow 2028 that has been cooled within the plenum system 2012. The mixed ambient airflow 2030, resulting from a combination of the plenum system ambient airflow 2028 and the ambient airflow 2024a, may be cooler than the ambient airflow 2024a, which may include recirculated air present around the one or more cooling systems 2002a, which may allow for improved cooling performance of the one or more cooling systems 2002a. The ambient airflow 2024a, the plenum system ambient airflow, and/or the mixed ambient airflow 2030 may be directed into and/or enter the cooling system 2002a. In some embodiments, the plenum system ambient airflow 2028 is the mixed ambient airflow 2030 (e.g., when the plenum system ambient airflow does not mix with the ambient airflow 2024a). The mixed ambient airflow 2030 may be forced and/or drawn into the cooling system 2002a by condenser fans.

The mixed ambient airflow 2030 may pass around or over the cooling system 2002a. The mixed ambient airflow 2030 may pass around or over the vent louvers 2006 and/or condenser coils and the cooling system 2002a may produce cooled airflow for a building. After passing through condenser coils, the mixed ambient airflow 2030 may become the discharged airflow 2032. The discharged airflow 2032 may be rejected from and/or exit the cooling system 2002a through the source/sink fans 2008.

In some embodiments, one or more directional control devices are positioned at or proximate to an outlet of the source/sink fan 2008. Directional control devices may include actuated vanes, pivoting diffusers, segmented shutters, and/or motorized louvers that adjust a discharge angle of the discharged airflow 2032, which may form a plume. A processor may automatically adjust the position of one or more directional control devices to optimize plume rise height, mitigate crosswind effects, and/or reduce plume collapse toward adjacent cooling systems 2002a. For example, the processor may be operable to control the directional control devices to respond to changes in temperatures of the ambient airflow 2028, the mixed ambient airflow 2030, predicted recirculation events, and/or real-time discharged airflow 2032 modeling.

In some embodiments, one or more aerodynamic surfaces are positioned above, around, or behind the source/sink fans 2008 to influence plume trajectory. Aerodynamic surfaces may utilize the Coand 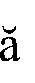 effect to further guide the discharged airflow 2032 upward, increase plume rise height, and/or induce a controlled jet attachment. Aerodynamic surfaces may be fixed or adjustable, smooth or textured, curved or faceted, and/or may be positioned to reduce lateral plume spreading.

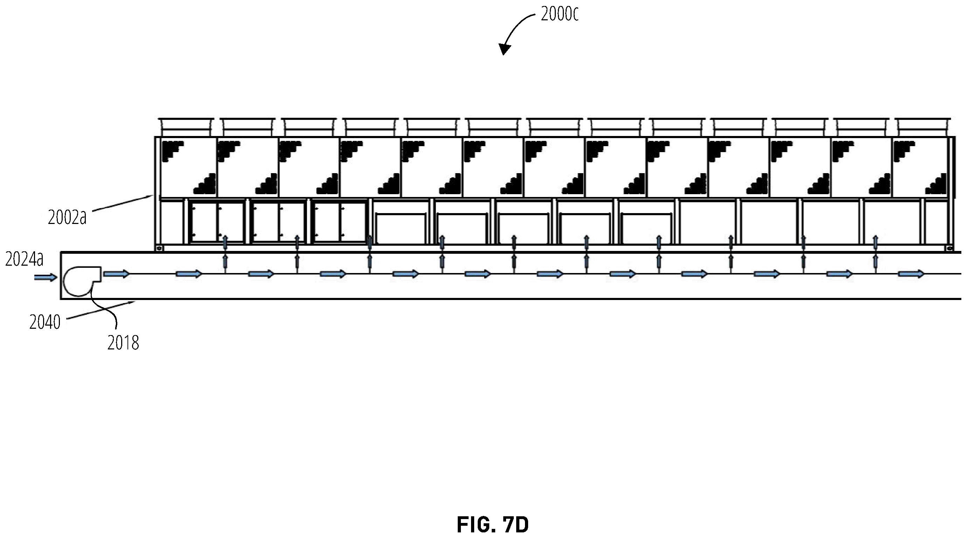

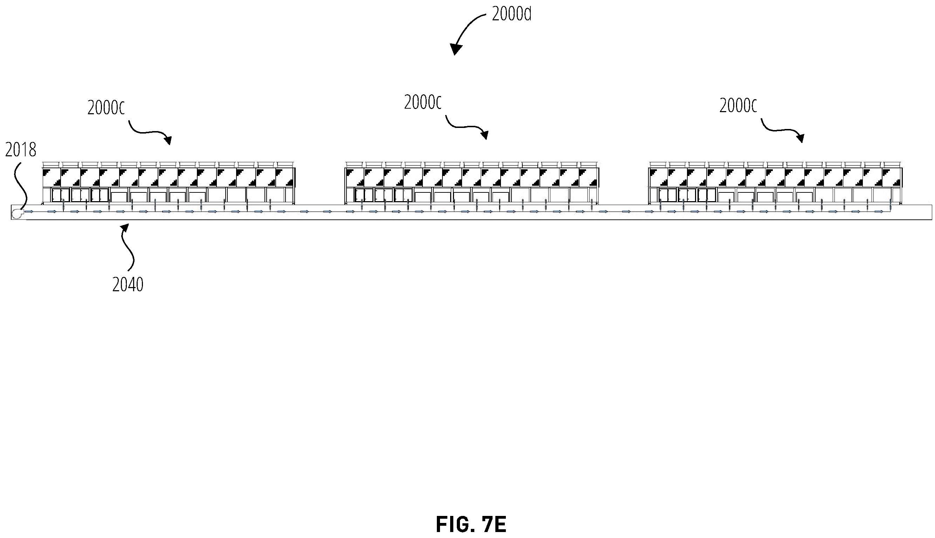

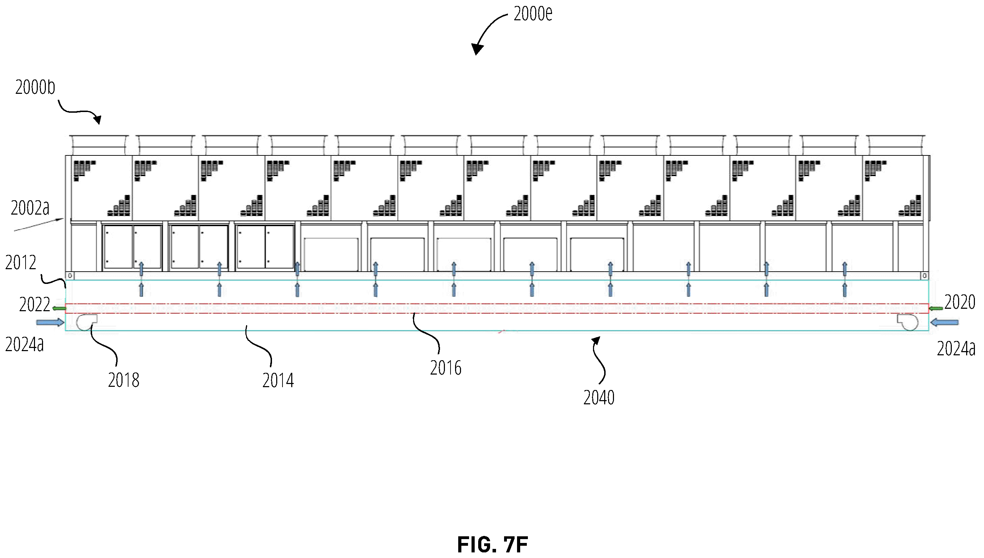

FIG. 7D illustrates a side view of an exemplary ventilation system 2000c in accordance with an embodiment of the disclosed subject matter. The ventilation system 2000c may include the cooling system 2002a with two or more condensers/chillers. In some embodiments, two or more of the structural bases 2010 (shown in FIG. 7A and FIG. 7B) may be coupled to form a plenum system channel 2040. The plenum system channel 2040 may allow for more even distribution of plenum system ambient airflow to displace discharged and/or recirculated airflow from each cooling system. When forming the plenum system channel 2040, each structural base 2010 used in the formation of the plenum system channel 2040 may be coupled to another structural base 2010 along at least any one side or end of another structural base 2010. The plenum system channel 2040 may be continuous, and may span a length and/or width of a ventilation system 2000c. In some embodiments, the structural bases 2010 of the plenum system channel 2040 form one or more substantially straight configurations. In some embodiments, the structural bases 2010 of the plenum system channel 2040 form one or more angled configurations. In some embodiments, the structural bases 2010 of the plenum system channel 2040 form a grid. A grid may be rectangular, square, or any other shape. In some embodiments, a ventilation system 2000c includes one, two, or more than two plenum system channels 2040. Each plenum system channel 2040 may include one or more openings to allow the plenum system ambient airflow 2028 to flow from each plenum system channel 2040 to cool each cooling system 2002a. One or more openings may be one or more gratings. Each plenum system channel 2040 may include one or more inline fans 2018 to draw the ambient air 2024a into each respective plenum system channel. The one or more inline fans 2018 may evenly distribute the ambient air 2024a throughout a length of the plenum system channel 2040. In some embodiments, the ventilation system 2000c may be combined with other ventilation systems 2000c to form a ventilation system 2000d, as shown in FIG. 7E, which illustrates a side view of the exemplary ventilation system 2000d in accordance with an embodiment of the disclosed subject matter. The ventilation system 2000d may include a plurality of the cooling systems 2002a (shown in FIG. 7D). In the example of FIG. 7E, one inline fan 2018 may be used in place of multiple inline fans within the plenum system channel 2040. In some embodiments, the one inline fan 2018 has a larger capacity to be used in place of multiple inline fans within the plenum system channel 2040. In some embodiments, the ventilation system 2000b may be combined with other ventilation systems 2000b to form a ventilation system 2000e, as shown in FIG. 7F, which illustrates a side view of an exemplary ventilation system 2000e in accordance with an embodiment of the disclosed subject matter. In the example of FIG. 7F, two inline fans 2018 may be positioned on each end of the plenum system channel 2040 in place of multiple inline fans within the plenum system channel 2040. In some embodiments, the two inline fans 2018 have a larger capacity to be used in place of multiple inline fans within the plenum system channel 2040.

Ventilation systems may be located in places with cold ambient temperatures to be able to handle the cooling load required for a data center. However, these ventilations systems that may include air-cooled chillers may experience challenges when starting and operating in cold ambient temperatures because of low refrigerant pressure and increased lubricant viscosity. Under low temperature conditions, a condenser can overcool refrigerant in a cooling system, resulting in low suction pressure that may cause trips or prevent startup of a compressor in a cooling system. Additionally, colder weather increases oil viscosity, which negatively affects lubrication efficiency of a cooling system. To address these issues, special controls, crankcase heaters, and head pressure management systems are commonly used to support reliable operation in cold environments, but these solutions have limitations.

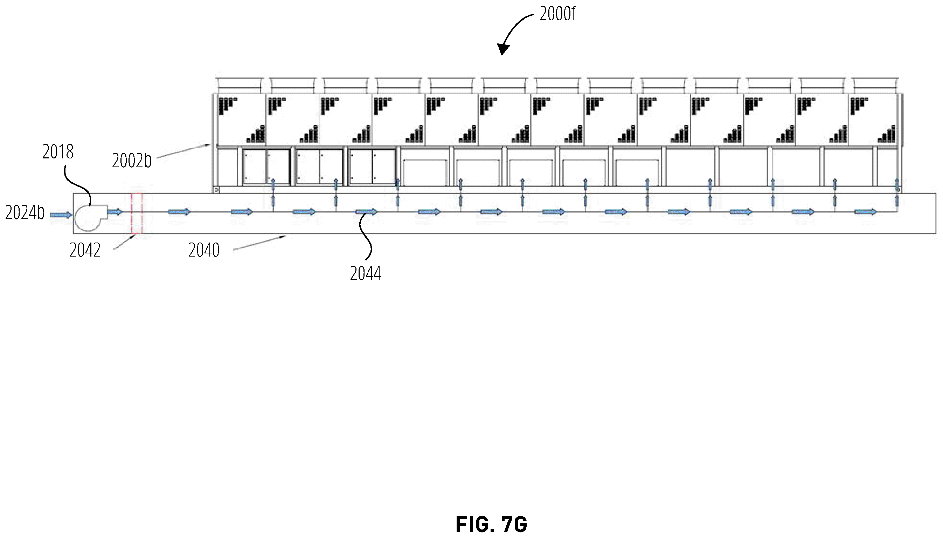

In some embodiments, a ventilation system may be fitted with a heat exchanger coil, such as a low ambient coil, at an inlet base to heat ambient airflow surrounding cooling systems and aid their performance in low ambient temperatures. FIG. 7G illustrates a side view of an exemplary ventilation system 2000f in accordance with an embodiment of the disclosed subject matter. The ventilation system 2000f may include a cooling system 2002b (including one or more air-cooled chillers), the inline fan 2018, an ambient airflow 2024b, the plenum system channel 2040, a low ambient coil 2042, and/or heated ambient airflow 2044. The cooling system 2002a of FIG. 7A - FIG. 7F and the cooling system 2002b of FIG. 7G - FIG. 7J may be substantially the same throughout the embodiments. In some embodiments, the cooling system 2002b may require additional changes to operation parameters based on differences in components of a ventilation system and/or differences in ambient temperatures. For example, temperatures of the ambient airflow 2024a of embodiments of ventilation systems shown in FIG. 7G - FIG. 7J may be substantially lower than temperatures of the ambient airflow 2024b of embodiments of ventilation systems shown in FIG. 7A - FIG. 7F. The differentiation of the ambient airflow 2024b versus the ambient airflow 2024a may represent a different in temperature. Some components of the structural base (e.g., the plenum system channel 2040 and/or an opening thereof) may be substantially the same as described for FIG. 7A - FIG. 7F.

In some embodiments, as shown in FIG. 7G, the ambient airflow 2024b is drawn into the plenum system channel 2040 by the inline fan 2018, and the ambient airflow 2024b is then passed over the low ambient coil 2042 to become the heated ambient airflow 2044. The ambient airflow 2024b may be sourced from an outdoor environment and/or be outside of a building. In some embodiments (e.g., as shown in FIG. 7A and FIG. 7B), the heated ambient airflow 2044 exits the plenum system channel 2040 into an ambient environment (e.g., an outdoor environment) of the cooling system 2002b. At least a portion of the heated ambient airflow 2044 may combine with the ambient airflow 2024b to create a mixed ambient airflow with a temperature that is higher than the ambient airflow 2024b. At least a portion of the heated ambient airflow 2044 may combine with the ambient airflow 2024b in an outdoor environment to create a mixed ambient airflow. The ambient airflow 2024b that mixes with the heated ambient airflow 2044 may be a "second" ambient airflow 2024b from the same source (e.g., an outdoor environment) as the ambient airflow 2024b that initially enters the plenum system channel 2040 (e.g., the ambient airflow 2024b may include a first ambient airflow which enters the plenum system channel 2040 and a second ambient airflow that mixes with the heated ambient airflow 2044 to create a mixed ambient airflow). A mixed ambient airflow may enter the cooling system 2002b and allow for improved cooling performance of the cooling system 2002b. A mixed ambient airflow may prevent overcooling of the cooling system 2002b, in comparison to the ambient airflow 2024b which has a lower temperature.

In some embodiments, the plenum system channel 2040 (and/or the plenum 2014 and/or the plenum system 2012, shown for example in FIG. 7A and FIG. 7B)is operable to recover energy rejected from building infrastructure. Exhaust methods can be through all fluid mediums, with air or water most commonly. Areas of buildings that may provide building infrastructure exhaust airflow (e.g., process heat, gases) include bathrooms, kitchens, laboratories, garages, laundry rooms, storage areas, workshops, data centers, boiler rooms, or other areas where pollutants and moisture accumulate. Equipment that may provide building infrastructure exhaust airflow include computer equipment, compressed air systems, steam systems, laundry facilities, kitchen equipment, and power generation equipment. For example, exhaust energy (e.g., waste heat) from industrial processes can be used in addition to, or in lieu of, the heated ambient airflow 2044. In another example, exhaust energy (e.g., boiler flue gases captured using economizers) can be used economizers to preheat the low ambient coil 2042. In a data center example, heat generated by servers and related computer equipment can be recovered. In other examples, waste heat from air compressors in compressed air systems can be reused, and or condensate from steam systems can be recovered. In a laundry facility examples, heat from dryer exhausts and hot water from washing processes can be recovered and reused. For kitchen equipment, heat from ovens, stoves, other cooking equipment, and appliances can be captured and/or reused, for example. In further examples, power generation equipment produces heat from generators and turbines that can be recovered. The foregoing are intend as examples and other examples are also envisioned for recycling building energy.

The plenum system channel 2040 may include plenums and/or ducts to collect building infrastructure exhaust airflow. In some embodiments, the plenum system channel 2040 is equipped with bypass dampers to allow building infrastructure exhaust airflow to exit if the cooling system is not in operation and/or if building infrastructure exhaust airflow is not needed (e.g., the ambient temperature 2024b is warm enough).

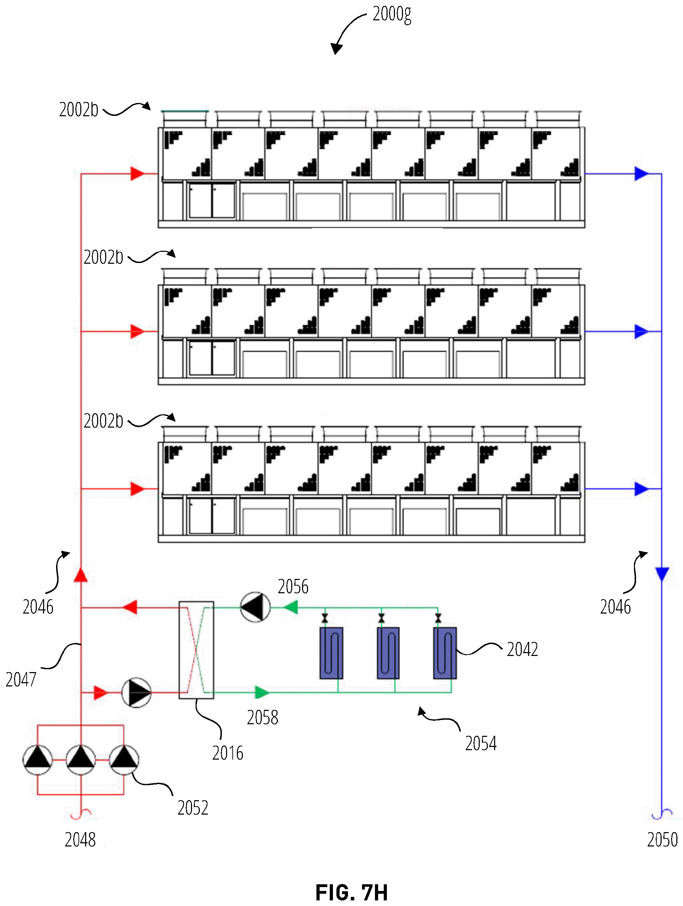

FIG. 7H illustrates a side view of an exemplary waterside diagram of a ventilation system 2000g in accordance with an embodiment of the disclosed subject matter. The ventilation system 2000g may include the cooling systems 2002b (including one or more chillers) as shown in FIG. 7G, the heat exchanger coil 2016 as shown in FIG. 7A - FIG. 7F, the low ambient coils 2042 as shown in FIG. 7G, a chilled water system 2046, a chilled water return 2048, a chilled water supply 2050, pumps 2052, a low ambient coil water system 2054, a low ambient coil waterflow entrance 2056, and/or a low ambient coil waterflow exit 2058. A ventilation system may include an "airside" and/or a "waterside." An airside ventilation system may use air (or an airflow mixture) as the fluid medium passed through at least part of a ventilation system (e.g., the one or more fans 2018, the plenum 2014, the plenum system channel 2040, and/or the one or more low ambient coils 2042, as previously shown and described in FIG. 7A - FIG. 7F). A waterside ventilation system may use water and/or glycol (or a water and/or glycol mixture) as the fluid medium passed through at least part of a ventilation system (e.g., the heat exchanger coil 2016, the low ambient coils 2042, the chilled water system 2046, the chilled water return 2048, the chilled water supply 2050, pumps 2052, the low ambient water system 2054, the low ambient coil waterflow entrance 2056, and the low ambient coil waterflow exit 2058). A ventilation system may include both an airside and waterside component. In some embodiments, the ventilation system 2000f shown in FIG. 7G, which is airside, and the ventilation system 2000g shown in FIG. 7H, which is waterside, may each be part of one ventilation system, with the ventilation system 2000f and the ventilation system 2000g connected through the low ambient coils 2042 (shown in both FIG. 7G and FIG. 7H). The ventilation system 2000g may include one or more low ambient coils 2042 per cooling system 2002b. For example, for the ventilation system 2000g including three cooling systems 2002b, the ventilation system 2000g may include three low ambient coils 2042 (one for each cooling system 2002b).

The ventilation system 2000g may include the chilled water system 2046 and/or the low ambient coil water system 2054. The chilled water system 2046 may include the cooling systems 2002b, the heat exchanger coil 2016, the chilled water return 2048, the chilled water supply 2050, and/or the pumps 2052. The low ambient coil water system 2054 may include the heat exchanger coil 2016, the one or more low ambient coils 2042, the low ambient coil waterflow entrance 2056, and/or the low ambient coil waterflow exit 2058. In some embodiments, each of the one or more low ambient coils 2042 has a corresponding low ambient coil waterflow entrance 2056 and a low ambient coil waterflow exit 2058. The chilled water system 2046 and the low ambient coil water system 2054 may connect through the heat exchanger coil 2016. In some embodiments, the ventilation system 2000g includes more than one heat exchanger coil 2016 (e.g., a capacity of one or more of the heat exchanger coils 2016 may match a capacity of one or more of the low ambient coils 2042). The cooling systems 2002b may be in parallel, and the low ambient coils 2042 may be in series with the cooling systems 2002b, as shown in FIG. 7H. The low ambient coils 2042 may use the return chilled water 2048 from a building to reduce cooling load of the cooling systems 2002b. In some embodiments, the low ambient coils 2042 may be fitted with the one or more pumps 2052 and/or the one or more heat exchangers 2016 to decouple the low ambient coil water system 2054 (e.g., the heat exchanger 2016 and/or one or more pumps 2052 may be removed from the low ambient coil water system 2052). The one or more pumps 2052 may be configured to circulate chilled water through the cooling systems 2002b (e.g., in being part of the chilled water system 2046). The one or more pumps 2052 may be located within the structural base 2010 (shown for example in FIG. 7A and FIG. 7B), inside of a building, outside of a building, any other location. In some embodiments, the chilled water system 2046 includes a bypass pipe 2047 that is used to bypass the low ambient coil water system 2054. The low ambient coil water system 2054, for example, may be bypassed when the ventilation system 2000g and/or one or more of the cooling systems 2002b is not utilizing the low ambient coils 2042. Note that bypass pipes are shown in other later examples and may be implemented in a similar manner.

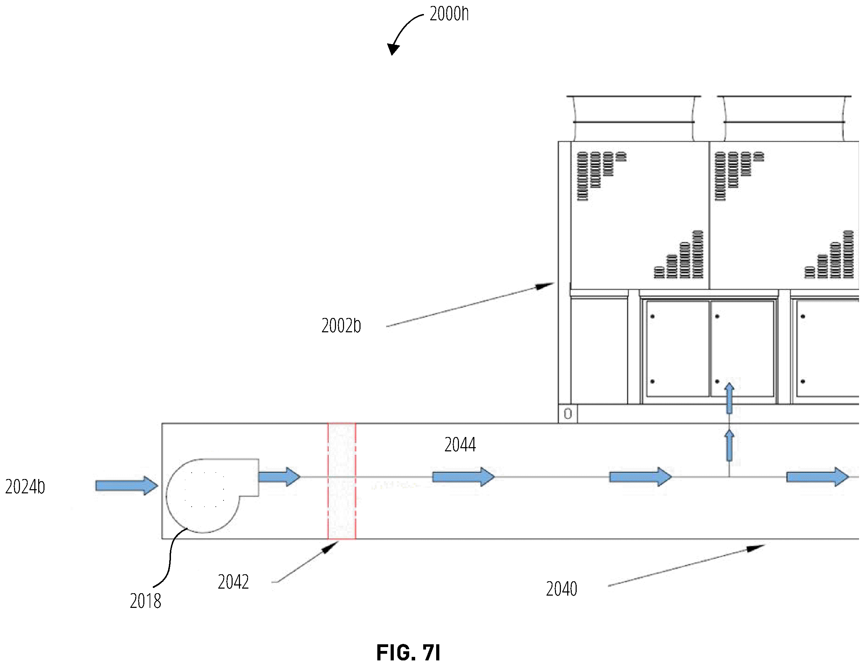

FIG. 7I illustrates a side view of an exemplary ventilation system 2000h in accordance with an embodiment of the disclosed subject matter. The ventilation system 2000h may include the cooling system 2002b (including one or more chillers), the inline fan 2018, the ambient airflow 2024b, the plenum system channel 2040, the low ambient coil 2042, and/or the heated ambient airflow 2044. In some embodiments, for a single cooling system operation, the cooling system 2002b is designed to operate at 400 tons of cooling capacity, the inline fan 2018 is sized for 100,000 CFM, the ambient airflow 2024b temperature is -40°F, and a water flow of the chilled water system 2046 is 600 GPM. Chilled water design temperatures are 76°F for the chilled water return 2048 and 60°F for the chilled water supply 2050, respectively. The low ambient coil 2042 is designed to take the ambient airflow 2024b temperature from -40°F to the heated ambient airflow 2044 temperature of -10°F to allow for safe cooling system 2002b operation.

A Total Heat Rejection of the one or more low ambient coils 2042 airside is calculated using the following equation: $Total Heat Rejection = SHC \times Airflow \times Δ T$ wherein Total Heat Rejection is an amount of BTU/hr rejected by the low ambient coil 2042. An exemplary range of the Total Heat Rejection may be from about 200,000 BTU/hr to about 13,750,000 BTU/hr, but may be higher or lower depending on a number and size of the low ambient coils 2042 in a system. SHC represents a Sensible Heat Constant (a conversion constant from multiplying a density of the ambient airflow 2024b, a specific heat of the ambient airflow 2024b, and a conversion factor of 60 minutes per hour). The Sensible Heat Constant may range from about 0.9 to about 1.15 (e.g., from about 1.05 to about 1.10) depending on elevation, temperature, and/or humidity. Airflow is an amount of airflow entering the low ambient coil 2042 measured in CFM, which may range from less than about 1,000 CFM to multiple millions of CFM (e.g., about 10,000 CFM to about 250,000 CFM). Δ*T* represents the difference in temperature between the heated ambient airflow 2044 exiting the low ambient coil 2042 and the ambient airflow 2024b entering the low ambient coil 2042, which may range from about -50°F to about 90°F (e.g., about 20°F to about 50°F).

In an example in which the SHC is 1.085 (calculated by multiplying an air density of 0.07535 1b/ft³, a specific heat of 0.24 Btu/lb·°F, and 60 minutes per hour), Airflow is 100,000 CFM, a temperature of the heated ambient airflow 2044 is -10°F, and a temperature of the ambient airflow 2024b is -40°F, a Total Heat Rejection of the low ambient coil 2042 may be calculated: $Total Heat Rejection = 1.085 \times 100 , 000 CFM \times \left(-10°F-\left(-40°F\right)\right)$ $Total Heat Rejection = 3 , 255 , 000 BTU / hr$ $3 , 255 , 000 BTU / hr = 271.25 Ton Cooling$

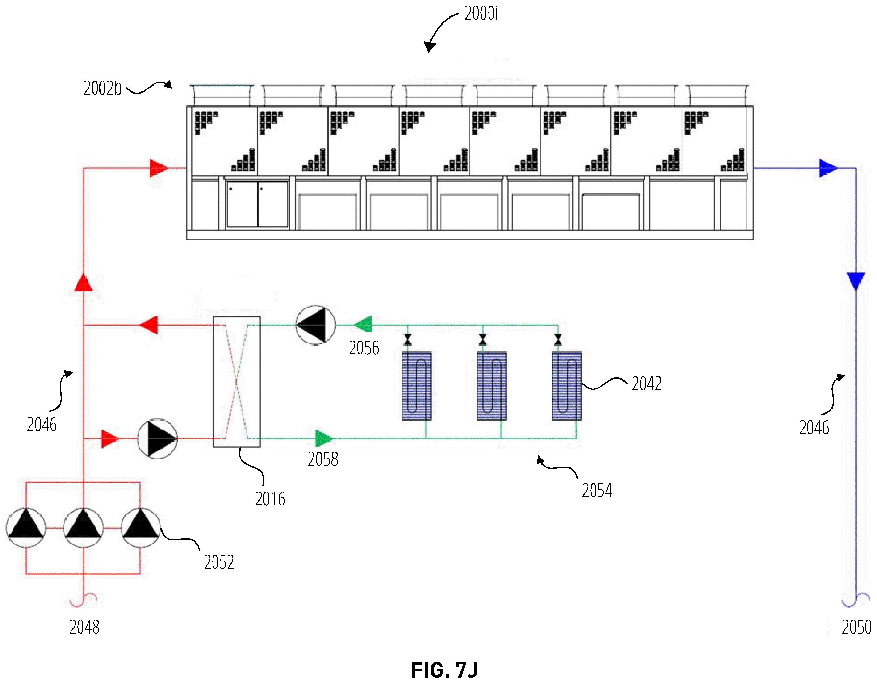

FIG. 7J illustrates a side view of an exemplary waterside diagram of a ventilation system 2000i in accordance with an embodiment of the disclosed subject matter. The ventilation system 2000i may include the cooling system 2002b (including one or more chillers), the heat exchanger coil 2016, the one or more low ambient coils 2042, the chilled water system 2046, the chilled water return 2048, the chilled water supply 2050, the pumps 2052, the low ambient coil water system 2054, the low ambient coil entrance waterflow 2056, and/or the low ambient coil exit waterflow 2058. In some embodiments, the low ambient coil water system 2054 and the chilled water system 2046 are separated by the heat exchanger coil 2016 with an approach temperature of about 4°F. An approach temperature may indicate loss of energy between the chilled water system 2046 and the low ambient coil water system 2054, ranging, for example, from about 1°F to about 6°F.

A Total Heat Rejection of the one or more low ambient coils 2042 waterside is calculated using the following equation: $Total Heat Rejection = CF \times Waterflow \times Δ T$ wherein Total Heat Rejection is an amount of BTUH rejected by the low ambient coils 2042, which may range from about 270,000 BTU/hr to about 13,750,000 BTU/hr, but may be higher or lower depending on a number and size of the low ambient coils 2042 in a system. CF represents a Constant Factor (a conversion constant from multiplying the specific heat capacity of water, the density of water, and a conversion factor of 60 minutes per hour), which may range from about 440 to about 510. Waterflow is an amount of waterflow passing through the low ambient coil water system 2054 measured in GPM, which may range from about 10 GPM to multiple thousands of GPM (e.g., 270 GPM to about 1,300 GPM). Δ*T* represents the difference in temperature between the low ambient coil exit waterflow 2058 and the low ambient coil entrance waterflow 2056, which may range from about 2°F to about 50°F (e.g., about 10°F to about 20°F).

In an example in which the CF is 500, a temperature of the low ambient coil exit waterflow 2058 is 72°F, a temperature of the low ambient coil entrance waterflow 2056 is 56°F, and the Total Heat Rejection is 3,255,000 BTUH, a Waterflow may be calculated: $3 , 255 , 000 BTUH = 500 \times Waterflow \times \left(72°F-56°F\right)$ $Waterflow = 406.8 GPM$ The ventilation systems 2000f, 2000g, 2000h, 2000i illustrated in FIG. 7G - FIG. 7J address operation of the cooling systems 2002b in cold climates. In addition, the ventilation systems 2000f, 2000g, 2000h, 2000i may function as energy recovery devices, allowing buildings to utilize free cooling when ambient conditions are suitable. Air-cooled cooling systems 2002b can operate at temperatures as low as about -10°F and offset about 271.25 tons of the required cooling load (as discussed in FIG. 7I, a required cooling load may be 400 tons). As a result, the cooling system 2002b may only required to produce about 128.75 tons to meet the overall demand.

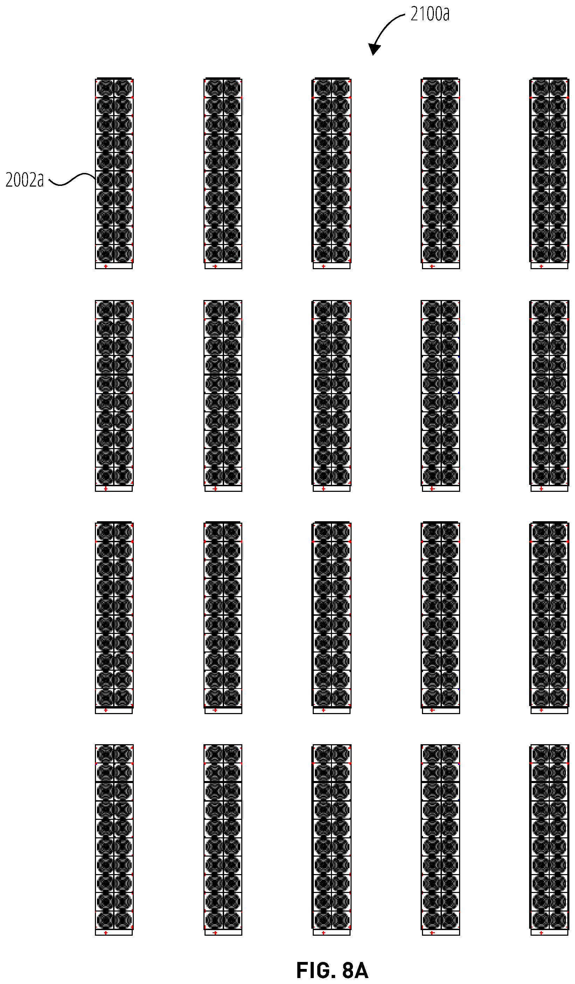

FIG. 8A illustrates a top-down view of an exemplary layout of a data center chiller plant 2100a in accordance with an embodiment of the disclosed subject matter. The chiller plant 2100a may include one or more of the cooling systems 2002a (or, in other embodiments, cooling systems 2002b). In some embodiments, twenty cooling systems 2002a (five columns and four rows of cooling systems 2002a) may be located on a roof of a data center. However, the cooling systems 2002a may be located in or on any other location of or around the data center.

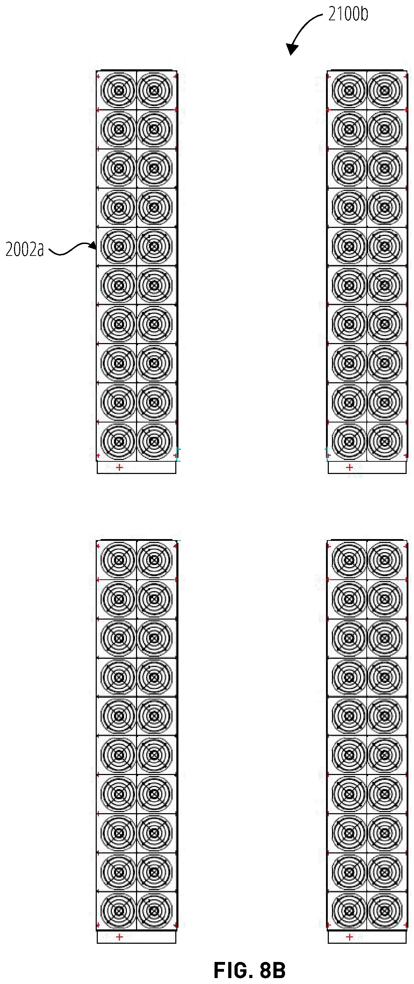

FIG. 8B illustrates a top-down view of a portion 2100b of the exemplary layout of the data center chiller plant 2100a in accordance with an embodiment of the disclosed subject matter. The portion of the chiller plant 2100b indicates an exemplary layout of dimensions between each of the cooling systems 2002a of the chiller plant 2100a. In some embodiments, the cooling systems 2002a may be spaced approximately fifteen feet from each other within each row (e.g., between each column) and approximately eight feet from each other between each row (e.g., within each column). In some embodiments, the cooling systems 2002a may be spaced approximately six feet to approximately twenty feet in any direction.

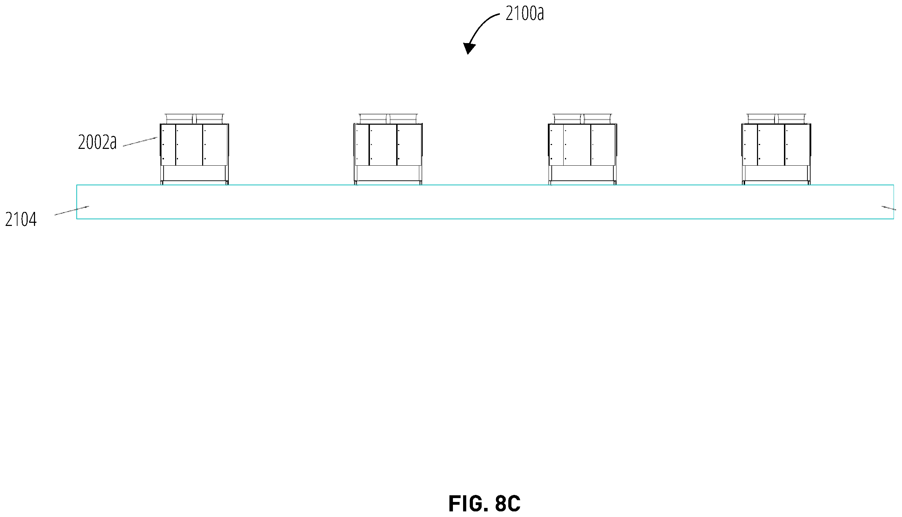

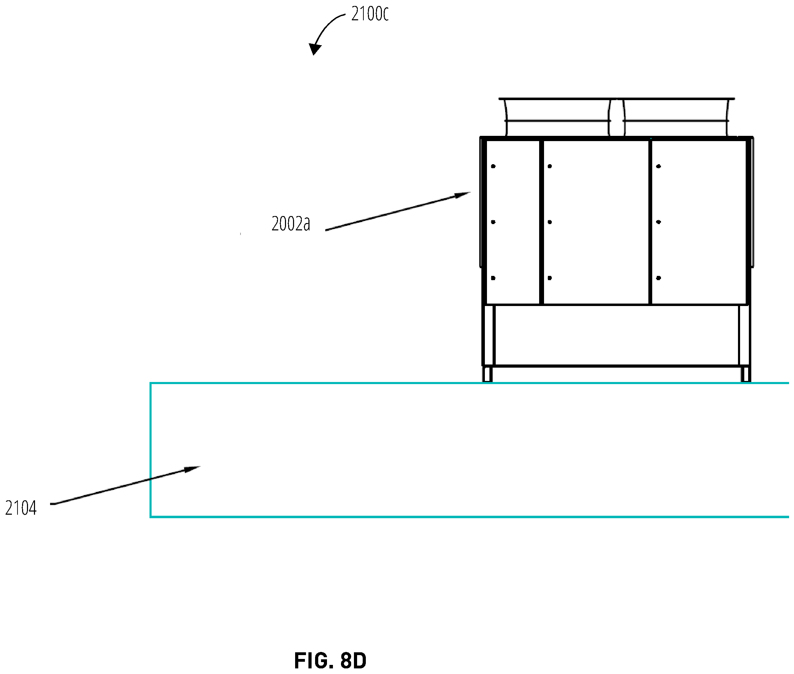

FIG. 8C illustrates a side view of the exemplary layout of the data center chiller plant 2100a in accordance with an embodiment of the disclosed subject matter. The cooling systems 2002a may be located, for example, four feet above a roof of a building. In some embodiments, the cooling systems 2002a may be located two feet to eight feet above a roof of a building. The cooling systems 2002a may be positioned on a dunnage 2104 above a building. The dunnage 2104 may be open and allow for ambient airflow beneath the cooling systems 2002a. In an embodiment, the dunnage 2104 (and/or dunnage system, which may support or enable one or more cooling systems and/or one or more of the dunnage systems) may be enclosed with walls to provide a plenum system that provides a plenum system ambient airflow. An exemplary plenum system by provided by an enclosed dunnage system that may include fans arranged around a perimeter thereof. Neutral or pressurized air within the exemplary dunnage system may be evenly dispersed through one or more openings of a dunnage system to displace discharged and/or recirculated air from one or more cooling systems. In some embodiments, the cooling systems 2002a may be positioned on any item or material that allows the cooling systems 2002a to be positioned above a building. FIG. 8D illustrates a side view of a portion 2100c of the exemplary layout of the data center chiller plant 2100a in accordance with an embodiment of the disclosed subject matter.

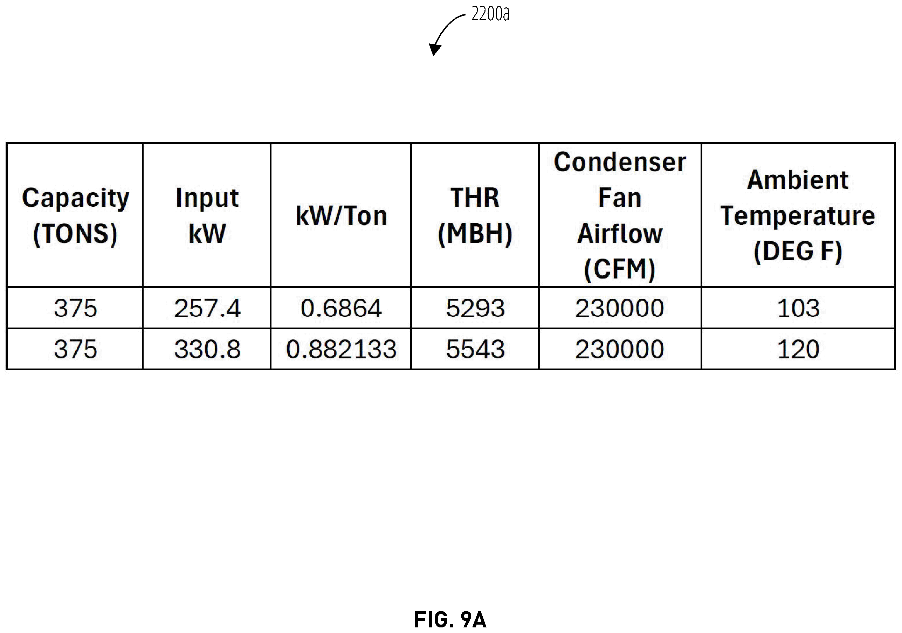

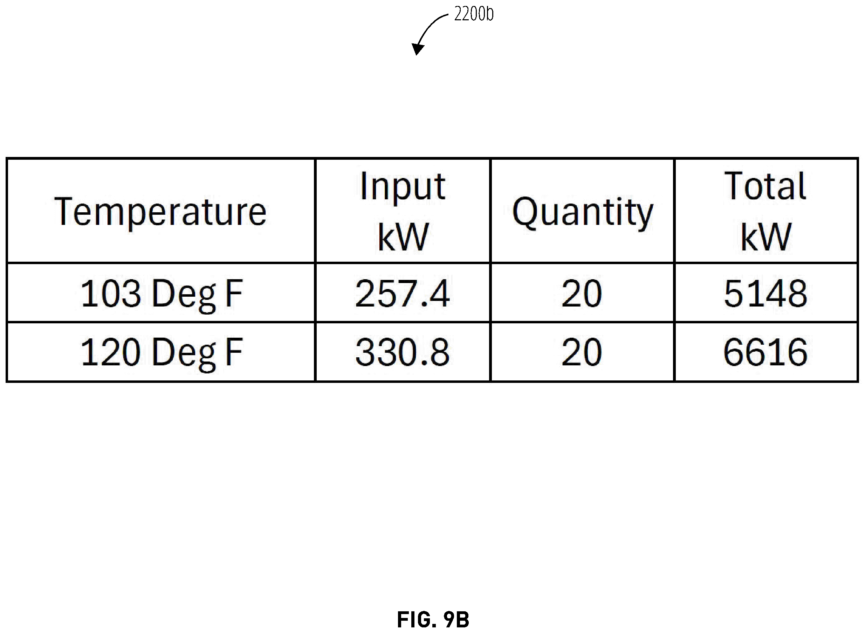

FIG. 9A illustrates a table 2200a comparing performances of two chillers at ambient temperatures of 103°F and 120°F, respectively, in accordance with an embodiment of the disclosed subject matter. In accordance with cooling systems as previously described (e.g., FIG. 7A - FIG. 7F), FIG. 9A and FIG. 9B may provide a data comparison for chillers and cooling systems, respectively, that use ambient airflow (103°F) versus recirculated discharged airflow (120°F).

In the table 2200a, each chiller has a capacity of 375 tons and condenser fan airflow of each chiller is 230,000 cubic feet per minute (CFM). An ambient temperature of 103°F is a design ambient temperature for a chosen location, however due to close footprint proximity, it is predicted that chillers would be operating as if an ambient temperature is 120°F due to recirculation. For example, to produce condenser fan airflow of 230,000 CFM at an ambient temperature of 103°F, a chiller may draw an input of 257.4 kW (73.19 tons, 0.6864 kW/ton). A total heat rejection (THR) of a chiller at an ambient temperature of 103°F is 5,378.28 thousand BTUs per hour (MBH) (441.08 tons), which may be a sum of a capacity of a chiller (375 tons) and an input draw of a chiller (73.19 tons). To produce condenser fan airflow of 230,000 CFM at an ambient temperature of 120°F, a chiller may draw an input of 330.8 kW (94.06 tons, 0.8821 kW/ton). A THR of a chiller at an ambient temperature of 120°F is 5,628.72 MBH. At a higher ambient airflow (or recirculated discharged airflow) temperature of 120°F compared to a lower ambient airflow temperature of 103°F, a chiller's THR is higher due to a higher input kW. A higher input kW is required at 120°F due to a higher energy needed to cool a higher airflow temperature.

FIG. 9B illustrates a table 2200b comparing aggregate performances of two cooling systems, each with twenty chillers, at ambient temperatures of 103°F and 120°F, respectively, in accordance with an embodiment of the disclosed subject matter. Twenty chillers at an ambient temperature of 103°F, each drawing an input of 257.4 kW, results in a total usage of 5,148 kW. Twenty chillers at an ambient temperature of 120°F, each drawing an input of 330.8 kW, results in a total usage of 6,616 kW. Therefore, a cooling system (or chiller) operating an ambient temperature of 103°F versus a cooling system (or chiller) operating at an ambient temperature of 120°F uses about 22% less energy. Improved performance of the cooling system may result in utilization of less energy, and conversely, a higher temperature of airflow (e.g., ambient airflow, recirculated airflow, etc.) that is input to a cooling system/chiller may result in less efficiency. As described in this example, a cooling system using mixed ambient airflow as described herein, as opposed to solely ambient airflow, may operate under similar conditions as a cooling system operating at 103°F versus a cooling system operating at an ambient temperature of 120°F as demonstrated in FIG. 9B, and may use about 30%, about 25%, about 22%, about 20%, about 15%, about 10%, or about 5% less energy compared to a cooling system using ambient airflow alone.

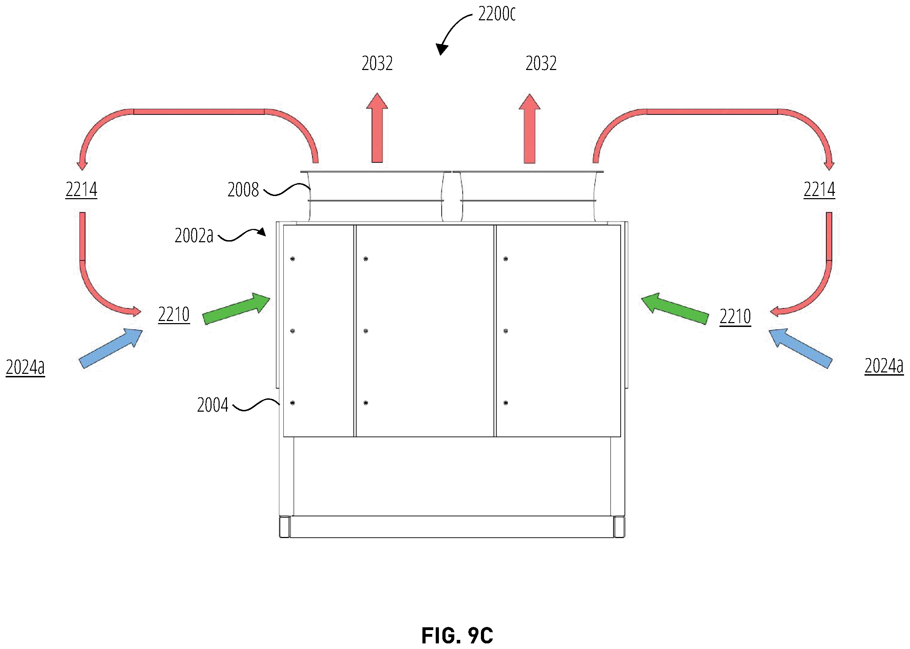

FIG. 9C illustrates a side view of an exemplary ventilation system 2200c that is improved by embodiments of the disclosed subject matter. The ventilation system 2200c may include the cooling system 2002a. In some embodiments, the ventilation system 2200c includes the cooling system 2002b. The cooling system 2002a may include the condenser 2004 and/or the source/sink fans 2008. The ventilation system 2200c may include the ambient airflow 2024a, the discharged airflow 2032, mixed ambient airflow 2210, and/or recirculated discharged airflow 2214. In some embodiments, the ventilation system 2200c may include the ambient airflow 2024b. The ventilation system 2200c may include a plenum system, and the mixed ambient airflow 2210 may be a combination of the ambient airflow 2024a and plenum system ambient airflow. In some embodiments, the mixed ambient airflow 2210 is solely the ambient airflow 2024a. The cooling system 2002a may be operating as if an ambient temperature is 120°F due to the recirculated discharged airflow 2214.

The mixed ambient airflow 2210 may pass through the cooling system 2002a to become the discharged airflow 2032. The discharged airflow 2032 may be rejected from and/or exit the cooling system 2002a through the source/sink fans 2008. At least a portion of the discharged airflow 2032 may be recirculated by the cooling system 2002a such that it becomes the recirculated discharged airflow 2214. The discharged airflow 2032 may be recirculated to become the recirculated discharged airflow 2214 due to a lack of the ambient airflow 2024a around one or more parts of the cooling system 2002a (e.g., the source/sink fans 2008). In some embodiments, one or more components of the cooling system 2002a (e.g., one or more additional fans) at least partially cause at least a portion of the discharged airflow 2032 to recirculate back towards the cooling system 2002a as the recirculated discharged airflow 2214.

In some embodiments, the mixed ambient airflow 2210 may include a combination of the ambient airflow 2024a, the recirculated discharged airflow 2214, and the plenum system ambient airflow 2028 (as shown in FIG. 7A and FIG. 7B). In some embodiments, the mixed ambient airflow 2210 may include a combination of the ambient airflow 2024b (as shown in FIG. 7G), the recirculated discharged airflow 2214, and the heated ambient airflow 2044 (as shown in FIG. 7G).

According to the disclosed systems and processes, the following examples and equations illustrate the improvements provided by the disclosed subject matter. When airflow entering the condenser 2004 is the ambient airflow 2024a, a temperature of the discharged airflow 2032 is calculated using the following equation: $Total Heat Rejection = SHC \times Airflow \times Δ T$ wherein Total Heat Rejection is an amount of BTU/hr rejected by the condenser 2004, which may range from about 10,000 BTU/hr to multiple millions of BTUH/hr (e.g., about 200,000 BTU/hr to about 13,750,000 BTU/hr), but may be higher or lower depending on a system. SHC represents a Sensible Heat Constant (a conversion constant from multiplying a density of the ambient airflow 2024a, a specific heat of the ambient airflow 2024a, and a conversion factor of 60 minutes per hour), which may range from about 0.9 to about 1.15. Airflow is an amount of airflow entering coils of the condenser 2004 measured in CFM, which may range from about 10,000 CFM to about 1,000,000 CFM. Δ*T* represents the difference in temperature between the discharged airflow 2032 and the ambient airflow 2024a entering the condenser 2004, which may range from about 5°F to about 50°F (e.g., about 20°F to about 50°F). The Total Heat Rejection and Airflow are both provided with selection data of a cooling system.

In an example in which Total Heat Rejection is 5,293,000 BTUH, SHC is 1.085, Airflow is 230,000 CFM, and a temperature of the ambient airflow 2024a entering the condenser 2004 is 103°F, a temperature of the discharged airflow 2032 may be calculated: $5 , 293 , 000 BTUH = 1.085 \times 230 , 000 CFM \times \left(Discharged Airflow-103°F\right)$ $21.2 ° F = Discharged Airflow - 103 ° F$ $Discharged Airflow = 124.2 ° F$

At a temperature of the ambient airflow 2024a of 103°F, an input kW to a condenser/chiller is 257.4 kW, as shown in FIG. 9A and FIG. 9B. A saturated condensing temperature of refrigerant of a condenser/chiller at a temperature of the ambient airflow 2024a of 103°F is 128.1°F.

In an example in which Total Heat Rejection is 5,543,000 BTUH, SHC is 1.085, Airflow is 230,000 CFM, and a temperature of the ambient airflow 2024a entering the condenser 2004 is 120°F, a temperature of the discharged airflow 2032 may be calculated: $5 , 543 , 000 BTUH = 1.085 \times 230 , 000 CFM \times \left(Discharged Airflow-120°F\right)$ $22.2 ° F = Discharged Airflow - 120 ° F$ $Discharged Airflow = 142.2 ° F$

At a temperature of the ambient airflow 2024a of 120°F, an input kW to a condenser/chiller is 330.8 kW, as shown in FIG. 9A and FIG. 9B. A saturated condensing temperature of refrigerant of a condenser/chiller at a temperature of the ambient airflow 2024a of 120°F is 145.9°F.

The following equation connects the mixed ambient airflow 2210, the ambient airflow 2210, and the recirculated discharged airflow 2214: $\begin{matrix}Mixed Ambient Airflow \left(°F\right) \\ = \left(Ambient Airflow \left(°F\right)\times Percent of Mixed Ambient Airflow \left(%\right)\right) \\ + \left(Recirculated Discharged Airflow \left(°F\right)\right) \\ \times Percent of Recirculated Discharged Airflow \left.\left(%\right)\right)\end{matrix}$

In an example in which a temperature of the Mixed Ambient Airflow 2210 is 120°F, a temperature of the Ambient Airflow 2024a is 103°F and the Ambient Airflow 2024a makes up 56.6% of the Mixed Ambient Airflow 2210 entering the condenser 2004, and a temperature of the Recirculated Discharged Airflow is 142.2°F, the percentage of the Mixed Ambient Airflow 2210 that is the Recirculated Discharged Airflow 2214 can be calculated (43.4%).

When the recirculated discharged airflow 2214 makes up 43.4% of the mixed ambient airflow 2210, and a total condenser fan airflow of the condenser 2004 is 230,000 CFM, multiplying the two values results in an amount of additional airflow required for a cooling system to operate at a design ambient airflow 2024a temperature of 103°F, which in this case, is 99,820 CFM.

In some embodiments, an additional airflow may be provided by a plenum system ambient airflow. A plenum system may be placed underneath or alongside the cooling system 2002a. A plenum system may include a plenum and inline fans within a plenum. Inline fans may pull in additional ambient airflow, which may then be ducted to the condenser 2004 to displace the recirculated discharged airflow 2214.

The following equation may be used to calculate a required amount of energy used by one or more inline fans in a plenum system (shown and referred to as the inline fans 2018 in FIG. 7A-7F): $Fan Energy = \frac{\left(Q\times SG\times SP\right)}{6356 \times Fan Efficiency}$ wherein a Fan Energy is measured in brake horsepower (BHP), which may range from about 1 BHP to multiple hundreds of BHP (e.g., about 5 BHP to about 100 BHP). Q is a flow rate measured in CFM, which may range from about 5,000 CFM to about 250,000 CFM. SG is a specific gravity of air, which may range from about 0.85 to about 1.20. SP is a static pressure measured in inches of water gauge (WG), which may range from about 0.1 inches to about 10.0 inches (e.g., about 0.2 inches to about 0.6 inches). 6356 is a constant used to convert air volume (measured in CFM) and static pressure (measured in inches of water gauge) to BHP considering standard air conditions (70°F at sea level), and Fan Efficiency is an efficiency of a fan, which may range from about 55% to about 90% (e.g., about 65% to about 80% represented as 0.65 and 0.80, respectively), or the like.

In an example in which the flow rate is 99,820 CFM (as calculated above), SG is 1.0, SP is 0.3", and fan efficiency is 0.75, Fan Energy may be calculated: $Fan Energy = \frac{\left(99,820 CFM\times 1.0\times 0.3 inches\right)}{6356 \times 0.75}$ $Fan Energy = 6.28 BHP = 4.86 kW$

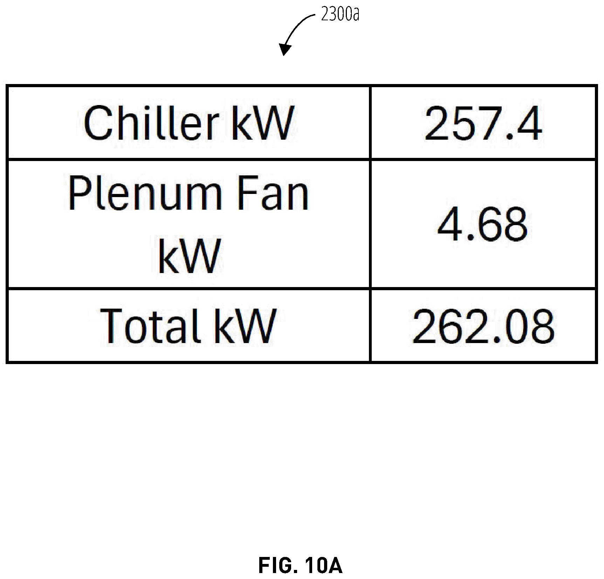

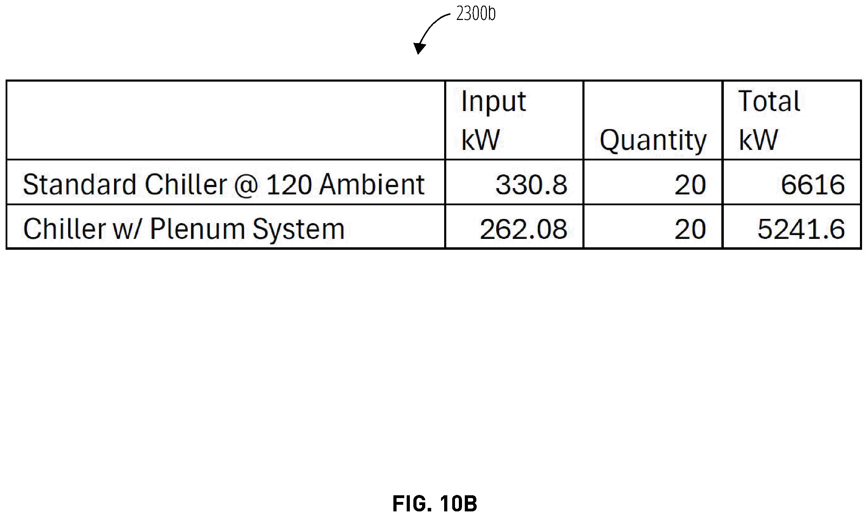

FIG. 10A illustrates a table 2300a displaying energy consumption of a chiller, an inline fan, and a chiller and inline fan combined in accordance with an embodiment of the disclosed subject matter. The values shown are based on the calculated values above. A chiller may use 257.4 kW and an inline fan may use 4.68 kW for a combined total of 262.08 kW. FIG. 10B illustrates a table 2300b comparing input energy consumption and total energy consumption of a standard cooling system and a cooling system utilizing a plenum system, with both systems operating at an ambient temperature of 120°F, in accordance with an embodiment of the disclosed subject matter. A standard cooling system having 20 chillers will use 330.8 kW of input energy per chiller for a total of 6616 kW. A cooling system using a plenum system and having 20 chillers will use 262.08 kW of input energy per chiller for a total of 5241 kW. The energy consumption by the cooling system incorporating a plenum system is approximately 20% less.

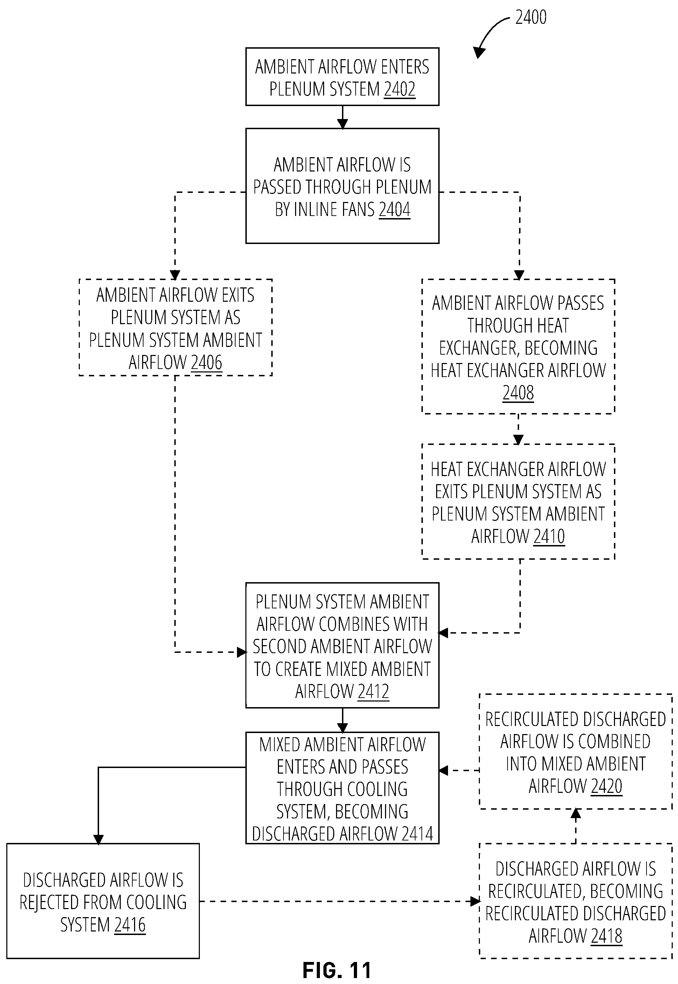

FIG. 11 illustrates an example method for an exemplary ventilation system in accordance with an embodiment of the disclosed subject matter. The process 2400 is an exemplary method for recycling discharged airflow of a cooling system. At block 2402, ambient airflow is enabled to enter a plenum system. Ambient airflow may be drawn into a plenum system by one or more inline fans of a plenum system. A plenum system may include one or more plenums. At block 2404, ambient airflow is passed through the one or more plenums of a plenum system by one or more inline fans. A first end of a plenum may include one or more inline fans, a second end of a plenum, and/or a first end and/or a second end of the plenum system may include one or more inline fans. Depending on an embodiment of a plenum system, ambient airflow may be directed in at least one of two methods. In a first example, ambient airflow exits a plenum system as plenum system ambient airflow (block 2406). In a second example, in which a plenum system includes a heat exchanger, ambient airflow passes around or over a heat exchanger and becomes heat exchanger airflow (block 2408). Then, the heat exchanger airflow exits a plenum system as plenum system ambient airflow (block 2410). A plenum system may include an opening to allow plenum system ambient airflow to exit a plenum system. At block 2412, plenum system ambient airflow is enabled to combine with ambient airflow to create mixed ambient airflow. In some embodiments, plenum system ambient airflow is enabled to combine with a second ambient airflow in an outdoor environment to create mixed ambient airflow. Mixed ambient airflow may be cooler or warmer than ambient airflow. At block 2414, mixed ambient airflow is pulled into, directed into, enters, and/or passes around or over a cooling system, becoming discharged airflow. At block 2416, discharged airflow is rejected from a cooling system. In some embodiments, at block 2418 discharged airflow is recirculated, becoming recirculated discharged airflow. At block 2420, recirculated discharged airflow is combined into a mixed ambient airflow (e.g., prior to a mixed ambient airflow entering a cooling system). A mixed ambient airflow may then be directed into a cooling system to restart a cycle of a cooling system. Additionally, the processing system 2034 shown and described in the example of FIG. 7C may be operable to execute control functions to implement and/or facilitate the process 2400 of FIG. 11, and the like.

In some embodiments, one or more directional control devices are positioned at or proximate to a discharged airflow opening (e.g., a source/sink fan) of a cooling system or any other equipment generating heated airflow, including but not limited to backup generators, engine-driven equipment, or combustion exhaust systems. Directional control devices may include actuated vanes, pivoting diffusers, segmented shutters, motorized louvers, variable-geometry nozzles, and/or airflow deflectors configured to adjust a discharged airflow angle, velocity profile, and/or trajectory.

For generator applications, directional control devices may be configured to redirect, elevate, and/or accelerate hot exhaust air or combustion gases to prevent such exhaust from being entrained into condenser inlets of nearby cooling systems. In some embodiments, directional control devices create a controlled jet or plume rise that projects generator exhaust upward or away from a cooling system area (e.g., a mechanical yard), which may reduce localized thermal contamination and prevent elevated condenser entering-air temperatures (e.g., ambient airflow that enters into a condenser and/or cooling system).

In yet another aspect, a ventilation system may include an attachment assembly, which may include one or more airflow-conditioning attachments/devices located at or proximate to a discharge of the cooling system, such as one or more straightener attachments, one or more venturi attachments, and/or one or more silencer attachments. One or more airflow-conditioning attachments/devices may be configured to modify a characteristic (e.g., a velocity profile, a velocity variation coefficient, a pressure distribution, and/or a flow direction) of a discharged airflow, which may reduce entrainment of recirculated air, promote upward momentum, and/or improve separation between condenser exhaust and condenser inlet air. An attachment assembly may be configured such that when a discharged airflow passes through the attachment assembly (e.g., from an outlet of a source/sink fan configured to exit a discharged airflow), a concentrated discharged airflow is created, which includes at least one modified characteristic compared to a discharged airflow. One or more airflow-conditioning devices/attachments may operate singularly or in combination with a plenum system (e.g., as described and shown previously), which may enable additional control over discharged airflow and/or concentrated discharged airflow trajectories and reducing a likelihood that discharged airflow and/or concentrated discharged airflow will re-enter a cooling system.

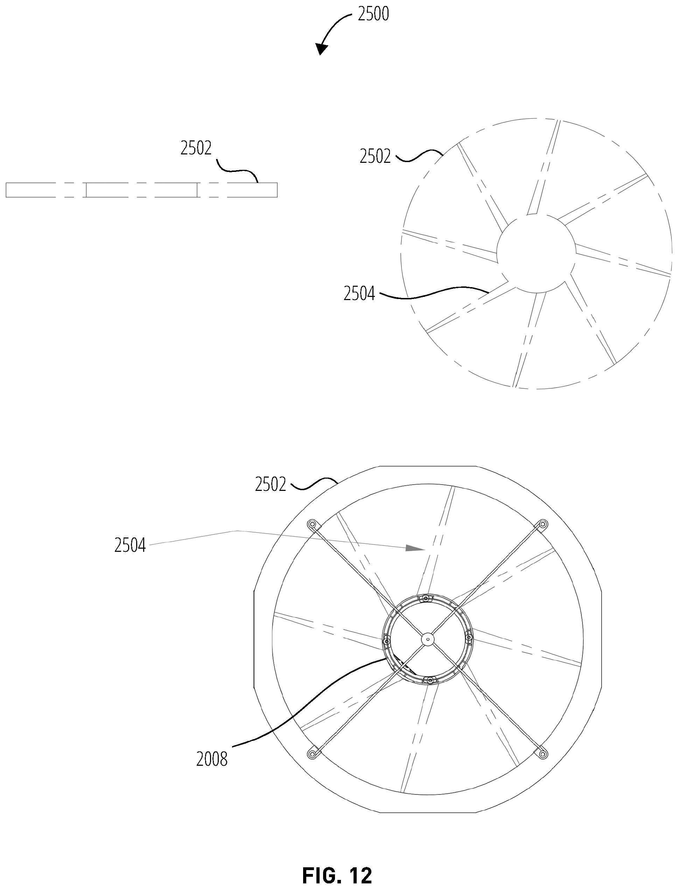

FIG. 12 illustrates a side view and top views of an straightener attachment 2500 in accordance with an embodiment of the disclosed subject matter. In some embodiments, a ventilation system includes the straightener attachment 2502 positioned downstream of the source/sink fan 2008 of a cooling system. The straightener attachment 2502 may include a set of air straightening blades 2504, fixed or adjustable vanes, a honeycomb matrix, a rectifier grid, or any other structure configured to reduce swirl of discharged airflow, equalize velocity of discharged airflow, and/or convert rotational kinetic energy of discharged airflow into axial flow. Straightening discharged airflow into a concentrated discharged airflow may result in a concentrated discharged airflow having a more uniform velocity profile and a higher axial momentum, which may decrease lateral spreading and reduce the likelihood that hot, discharged airflow and/or concentrated discharged airflow will be entrained back toward a condenser inlet.

The straightener attachment 2502 may be constructed from sheet metal, molded polymers, composite materials, and/or other rigid structures. The straightener attachment 2502 may be cylindrical, polygonal, conical, or matched to a geometry of an outlet of the source/sink fan 2008. In some embodiments, the straightener attachment 2502 attaches directly to a source/sink fan 2008 ring or source/sink fan 2008 guard using mechanical fasteners or integral mounting tabs. An attachment mechanism may include, without limitation, bolted connections, snap-fit assemblies, clamp rings, adhesive bonding, and/or welded joints. The straightener attachment 2502 may be sized to accommodate a diameter of the source/sink fan 2008 ranging from about 0.3 meters to about 3 meters or more, depending on a cooling system capacity and configuration.

In some embodiments, the straightener attachment 2502 is passive (e.g., requiring no external power or control). In other embodiments, the straightener attachment 2502 may include adjustable pitch vanes and/or a controlled orientation mechanism tied to a processor, which may allow/be configured to make real-time concentrated discharged airflow adjustments based on ambient airflow temperature, discharged airflow temperature, concentrated discharged airflow temperature, operating mode, and/or recirculation detection. Adjustable vanes may be actuated by stepper motors, servo motors, pneumatic actuators, and/or linear actuators that may be controlled by a programmable logic controller (PLC), microcontroller, and/or a distributed control system (DCS). A vane pitch angle may be adjusted within a range of about 0 degrees to about 45 degrees relative to an axial flow direction, or within any subrange thereof, such as about 5 degrees to about 30 degrees, about 10 degrees to about 25 degrees, and/or about 15 degrees to about 20 degrees.

The air straightening blades 2504 of the straightener attachment 2502 may pass air through a set of blades (e.g., thinwall blades) mounted on a discharge of an outlet of the source/sink fan 2008 (e.g., to damp out the turbulence). The air straightening blades 2504 may be configured to straighten rotating discharged airflow. Thinwall blades may include either metal and/or molded plastic, and may be designed to resist ambient conditions (e.g., the air straightening blades 2504 and/or thinwall blades may be weather-resistant). Thinwall blades may be static (e.g., they do not move). Straightening discharged airflow off of the source/sink fan 2008 (e.g., using thinwall blades) may increase velocity of discharged airflow by converting turbulent, rotational energy into forward-moving kinetic energy that may be useful to help a cooling system regain static pressure.

Discharged airflow leaving the source/sink fan 2008 may naturally have an unpredictable and/or swirling motion (e.g., vortices) due to a rotation of blades of the source/sink fan 2008. This turbulence may include wasted kinetic energy because air molecules are moving in many sporadic directions rather than one (e.g., straight) direction. Discharge straighteners (e.g., vanes or honeycomb structures) may minimize these lateral velocity components and align air molecules to travel parallel to each other. A straightening effect of the straightener attachment 2502 may reduce/is configured to reduce turbulence intensity of discharged airflow by about 30% to about 80%, or by any value or subrange within that range, such as about 40% to about 70%, about 45% to about 65%, and/or about 50% to about 60%.

By reducing swirl, discharged airflow may be forced into a more uniform, steady, and/or concentrated stream (e.g., concentrated discharged airflow). Concentrated discharge airflow may be more efficient at moving mass in a specific direction. A velocity profile uniformity of a concentrated discharged airflow may be characterized by a velocity variation coefficient of less than about 0.3, less than about 0.2, less than about 0.15, and/or less than about 0.1 across a cross-section of a concentrated discharged airflow.

A more uniform/less turbulent flow profile may allow a cooling system to regain static pressure that would otherwise be lost to dynamic losses (e.g., caused by changes in direction and velocity). According to Bernoulli's principle, an increase in an efficiency of a static pressure conversion allows for a corresponding increase in velocity of directed airflow, as a total energy within a system is conserved (minus frictional losses). A static pressure recovery may range from about 10 Pa to about 100 Pa, or any value or subrange within that range, such as about 20 Pa to about 80 Pa, about 30 Pa to about 70 Pa, and/or about 40 Pa to 60 Pa.

Because the source/sink fan 2008 may no longer be working as hard to overcome cooling system resistance from turbulence, an overall efficiency of air movement of a cooling system improves. Energy imparted by the source/sink fan 2008 may be used more effectively to accelerate discharged airflow in an intended direction. In essence, the straightener attachment 2502 may allow energy the source/sink fan 2008 adds to discharged airflow to be directed toward a single, purposeful stream (e.g., concentrated discharged airflow), which may result in a higher, more effective exit velocity of a discharged airflow and/or prevent discharged airflow recirculation in a cooling system.

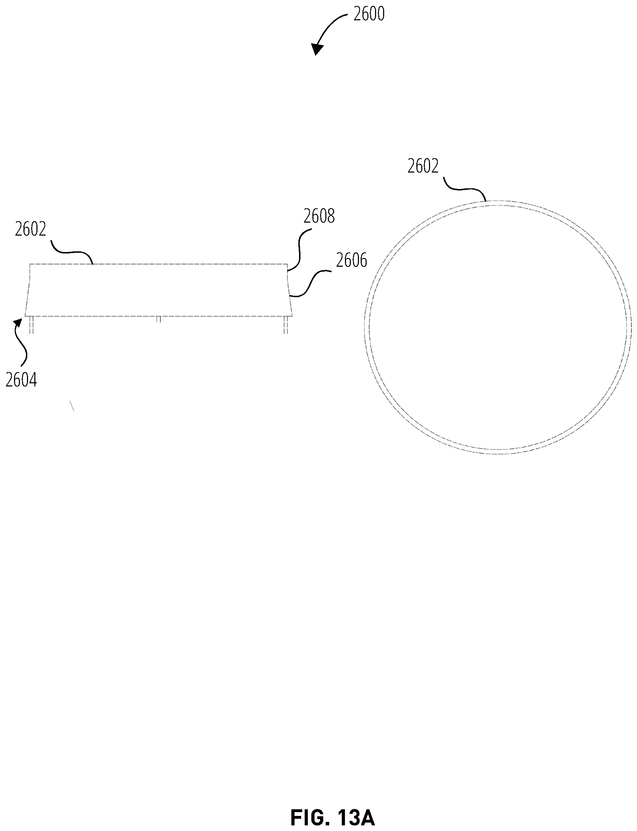

FIG. 13A illustrates a side view and a top view of an exemplary venturi attachment 2600 in accordance with an embodiment of the disclosed subject matter. In certain embodiments, a venturi attachment 2602 may be coupled to the source/sink fan 2008 (shown previously). The venturi attachment 2602 may include a venturi-shaped outlet nozzle configured to increase an exit velocity of a discharged airflow and/or reduce pressure of the source/sink fan 2008 at an outlet perimeter. A geometry of the venturi attachment 2602 may include a converging section 2604, a throat 2606 sized to accelerate discharged airflow, and/or a diverging section 2608 designed to recover pressure (e.g., without inducing backflow). The converging section 2604 may have a convergence angle ranging from about 10 degrees to about 45 degrees, or any value or subrange within that range. A diameter of the throat 2606 may be sized at about 60% to about 95% of an outlet diameter of the source/sink fan 2008, or any value or subrange within that range, such as about 70% to about 90%, about 75% to about 85%, or about 78% to about 82%. The diverging section 2608 may have a divergence angle ranging from about 3 degrees to about 15 degrees, or any value or subrange within that range, such as about 5 degrees to about 12 degrees, about 6 degrees to about 10 degrees, and/or about 7 degrees to about 9 degrees.

The venturi attachment 2602 may increase an effective plume height of a discharged airflow, which may create a narrower and/or more energetic concentrated discharged airflow that is less prone to rolling back toward a condenser coil plane. A plume height increase may range from about 1 meter to about 10 meters, or any value or subrange within that range, such as about 2 meters to about 8 meters, about 3 meters to about 7 meters, or about 4 meters to about 6 meters, depending on capacity of the source/sink fan 2008, ambient conditions, and/or geometry of the venturi attachment 2602.

The venturi attachment 2602 may be formed from stamped metal, molded or extruded polymers, fiberglass, composite shells, and/or segmented components that attach to an outlet of the source/sink fan 2008. The venturi attachment 2602 may include straightening vanes, aerodynamic ribs, and/or noise-reducing features such as serrated edges and/or perforated liners. Straightening vanes within the venturi attachment 2602 may be positioned in the converging section 2604, the throat 2606, and/or the diverging section 2608, and/or may be oriented axially, radially, and/or at an angle to optimize flow conditioning.

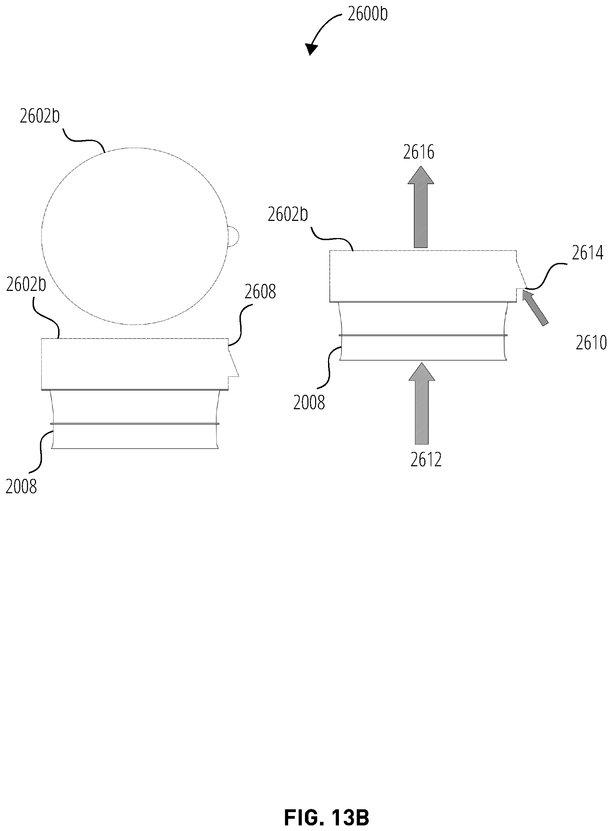

FIG. 13B illustrates side views and a top view of an exemplary venturi attachment 2600b in accordance with an embodiment of the disclosed subject matter.

In some embodiments, an outlet of the venturi attachment 2602b is shaped to create controlled induction that draws a small quantity of ambient airflow 2610 (e.g., about 5% to about 20% of airflow from the source/sink fan) into the diverging section 2608, which may increase plume dilution. A discharged airflow 2612 from a cooling system may pass through the source/sink fan 2008 and the ambient airflow 2610 may enter the venturi attachment 2602 through annular gaps 2614, perforations, slots, and/or louvers that may be positioned at or near a throat-to-diverging section transition of the venturi attachment 2602. The discharged airflow 2614 and the ambient airflow 2610 may combine within the venturi attachment 2602b and exit as concentrated discharged airflow. An induction ratio may be controlled by adjusting a size, number, and/or position of induction openings.

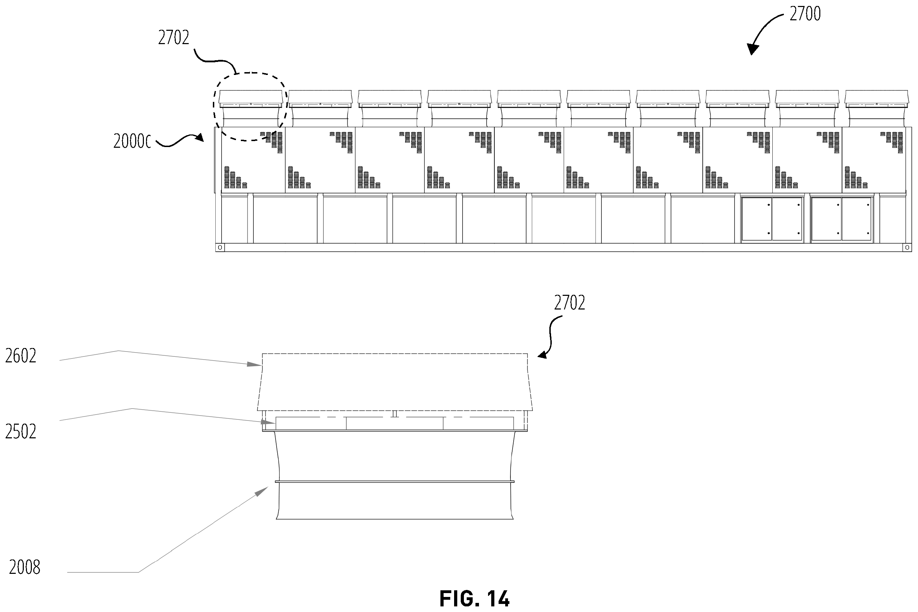

FIG. 14 illustrates a side view of an exemplary ventilation system 2700 in accordance with an embodiment of the disclosed subject matter. The ventilation system 2700 may include the cooling system 2002c, or any other cooling system. The cooling system 2002c may include a straightener-venturi assembly 2702 that integrates the straightener attachment 2502 and the venturi attachment 2602 into a single assembly. The straightener attachment 2502 may allow a uniform, swirl-free concentrated discharged airflow entering the throat 2606 of the venturi attachment 2602, which may increase a stability of a concentrated discharged airflow. A combined effect may produce increased plume rise, reduced lateral spreading, reduced susceptibility to crosswinds, minimized recirculation toward condenser inlets, and/or improve a temperature of ambient airflow entering a condenser.

In some embodiments, the venturi attachment 2602 is mounted above the straightener attachment 2502 (e.g., the air straightening blades 2504 of the straightener attachment 2502) which may increase an amount of discharged airflow by creating suction at the source/sink fan 2008 (e.g., mixing ambient airflow with output of the source/sink fan 2008). A constricted passage formed by the venturi attachment 2602 and the straightener attachment 2502 may speed up a discharged airflow and/or draw in extra airflow to the source/sink fan 2008, boosting a total volume moved beyond the source sink fan's 2008 mechanical output. When a discharged airflow of the source/sink fan 2008 is forced through the narrow throat 2606 of the venturi attachment 2602, a speed of a concentrated discharged airflow may increase and a pressure of a concentrated discharged airflow may decrease, according to the Bernoulli principle.

A resulting low-pressure zone around the source/sink fan 2008 may create suction, drawing in surrounding ambient airflow from the atmosphere or another source. This entrained ambient airflow may be pulled into a high-velocity discharged airflow, and a combined flow may move at a higher volume than the original discharged airflow of the source/sink fan 2008 alone. An entrainment coefficient may range from about 0.05 to about 0.25, or any value or subrange within that range, representing a ratio of entrained ambient airflow mass flow to discharged airflow mass flow.

Benefits to a cooling system of the straightener attachment 2502 and/or the venturi attachment 2602 may include a higher volume of discharged airflow/concentrated discharged airfloe from a cooling system and/or discharged airflow/concentrated discharged airflow traveling higher and/or with greater velocity. This may minimize time for a discharged airflow/concentrated discharged airflow to recirculate and/or puts discharged airflow/concentrated discharged airflow higher into an ambient airflow for better heat exchange and/or lower potential recirculated airflow temperatures. A reduction in recirculation may decrease a temperature of ambient airflow or mixed ambient airflow entering a condenser by about 0.5°C to about 5°C, or any value or subrange within that range, such as about 1°C to about 4°C, about 1.5°C to about 3.5°C, or about 2°C to about 3°C, which may result in improved cooling system efficiency and/or reduced energy consumption.

The straightener-venturi assembly 2702 may be used with or without the plenum system 2012 described previously. When used together, the plenum system 2012 may manage inlet ambient airflow quality while the straightener-venturi assembly 2702 may manage discharged airflow/concentrated discharged airflow behavior, which may provide a comprehensive solution for eliminating condenser air recirculation. This dual-approach system may address both inlet and outlet sides of the cooling system 2002c, which may maximize overall performance improvement.

In some embodiments, the cooling system 2002c includes a sensor system including one or more sensors configured to measure discharged airflow temperature, plume velocity, static pressure, ambient air temperature, recirculation index, and/or any other air metric of discharged airflow, concentrated discharged airflow, and/or ambient airflow. A controller may be configured to modulate a geometry and/or opening position of an attachment assembly based on sensor measurements to control a discharged airflow/concentrated discharged airflow (e.g., a geometry of adjustable vanes within the straightener-venturi assembly 2702 may be modulated to optimize plume height and/or minimize recirculation). Sensors may include thermocouples, resistance temperature detectors (RTDs), thermistors, hot-wire anemometers, pitot tubes, pressure transducers, and/or infrared temperature sensors. A controller may implement proportional-integral-derivative (PID) control, model predictive control (MPC), fuzzy logic control, and/or adaptive control algorithms.

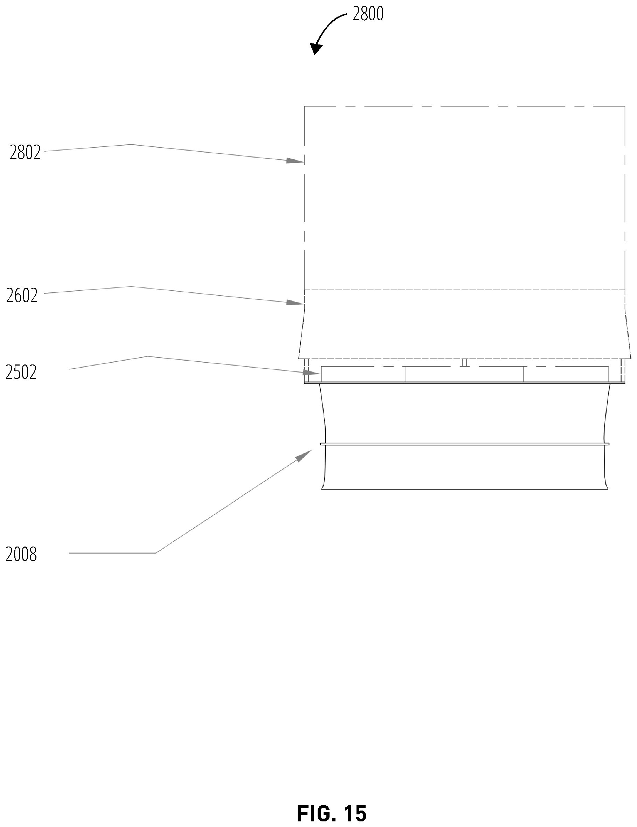

FIG. 15 illustrates a side view of an attachment assembly 2800 in accordance with an embodiment of the disclosed subject matter. The silencer attachment assembly may include a silencer attachment 2802, the venturi attachment 2602, the straightener attachment 2502, and/or the source/sink fan 2008. In some embodiments, a ventilation system includes the silencer attachment 2802 integrated with or attached to an outlet of the source/sink fan 2008. The silencer attachment 2802 may reduce fan-generated noise and simultaneously modify discharged airflow/concentrated discharged airflow characteristics to minimize recirculation. The silencer attachment 2802 may include acoustically absorptive media, perforated liners, baffles, concentric tubes, dissipative or reactive chambers, and/or combinations thereof. The silencer attachment 2802 may be cylindrical, rectangular, polygonal, or formed to match a geometry of a condenser fan outlet.

In addition or alternatively to acoustic attenuation, the silencer attachment 2802 may be configured to shape and/or stabilize a discharged airflow, and/or function in part as a flow straightener, a velocity equalizer, a jet-stabilizing duct, and/or an aerodynamic nozzle. Because many geometries of the silencer attachment 2802 may naturally suppress swirl and smooth turbulence intensity, the silencer attachment 2802 may increase an axial component of velocity of a discharged airflow leaving the source/sink fan 2008. This enhanced axial momentum may promote increased plume rise height and/or reduce a likelihood that a discharged airflow will entrain back toward a condenser inlet plane.

In some embodiments, the silencer attachment 2802 includes an internal honeycomb rectifier, vortex-suppressing vanes, and/or laminarizing channels to further condition a discharged airflow. The silencer attachment 2802 may transition into a venturi-shaped outlet, which may combine acoustic attenuation, swirl reduction, and/or jet acceleration into a single structure. A honeycomb rectifier may have cell sizes ranging from about 3 mm to about 25 mm, or any value or subrange within that range, such as about 5 mm to about 20 mm, about 8 mm to about 15 mm, or about 10 mm to about 12 mm. A cell length-to-diameter ratio may range from about 4:1 to about 12:1, or any value or subrange within that range.

In some embodiments, the straightener attachment 2502, the venturi attachment 2602, and the silencer attachment 2802 are integrated as a single, multi-function attachment assembly 2800. These integrated devices 2502, 2602, 2802 may concurrently reduce acoustic emissions, lower turbulence intensity, straighten discharged airflow, narrow a plume shape, increase vertical momentum, and/or minimize recirculation toward condenser inlets. Materials of the attachment assembly 2800 may include galvanized steel, aluminum, composite materials, molded polymers, fiberglass, and/or acoustically-tuned liners designed for outdoor environments. The attachment assembly 2800 may be retrofittable to existing cooling systems or incorporated into factory-built systems.

In some embodiments, the silencer attachment 2802 includes adjustable acoustic baffles and/or tunable sections controlled by a controller. These components may allow dynamic optimization for noise, plume stability, and/or recirculation avoidance based on operating mode, load, ambient temperature, and/or site-specific airflow conditions. Adjustable baffles may be positioned using motorized actuators, and tuning may be based on real-time acoustic measurements, vibration analysis, and/or computational fluid dynamics (CFD) modeling.

The airflow-conditioning devices 2502, 2602, 2602b, 2702, 2800, 2802 may be used on and/or with air-cooled cooling systems (e.g., chillers), air-source heat pumps, dry coolers, packaged DX units, cooling towers, or any application where condenser discharged airflow/exhaust recirculation is present. The devices 2502, 2602, 2602b, 2702, 2800, 2802 may be scaled for residential, commercial, and/or industrial applications, with cooling capacities ranging from about 10 kW to about 10,000 kW or more.

### EMBODIMENTS

Embodiment 1: A ventilation system having a plenum system, comprising: a cooling system, wherein the cooling system includes: a condenser, condenser coils, and a source/sink fan; and a structural base including the plenum system, wherein the plenum system includes: a plenum, a heat exchanger coil, and one or more inline fans; wherein the one or more inline fans are operable to draw an ambient airflow into the plenum, the ambient airflow passes around or over the heat exchanger coil and undergoes a temperature change to create heat exchanger airflow, the heat exchanger airflow exits the plenum system as plenum system ambient airflow, the plenum system ambient airflow combines with a second ambient airflow in an outdoor environment to create a mixed ambient airflow, and the mixed ambient airflow enters the cooling system to allow for improved performance of the cooling system compared to performance of the cooling system when the ambient airflow alone is used.

Embodiment 2: The ventilation system of embodiment 1, wherein the mixed ambient airflow enters the cooling system by passing around or over the condenser coils.

Embodiment 3: The ventilation system of embodiment 1, wherein the structural base is positioned beneath the cooling system.

Embodiment 4: The ventilation system of embodiment 1, wherein the plenum system spans a length of the cooling system.

Embodiment 5: The ventilation system of embodiment 1, wherein the plenum includes a first end and a second end configured to draw in the ambient airflow.

Embodiment 6: The ventilation system of embodiment 1, wherein the ventilation system includes a plurality of cooling systems.

Embodiment 7: The ventilation system of embodiment 6, wherein the ventilation system includes a plurality of structural bases coupled to form a plenum system channel.

Embodiment 8: The ventilation system of embodiment 1, wherein the ambient airflow is cooled by the heat exchanger coil.

Embodiment 9: The ventilation system of embodiment 1, wherein the ambient airflow is heated by the heat exchanger coil.

Embodiment 10: The ventilation system of embodiment 1, wherein the improved performance of the cooling system using the mixed ambient airflow includes utilization of less energy than when the cooling system uses the ambient airflow alone.

Embodiment 11: A method of using a ventilation system having a plenum system, comprising: enabling an ambient airflow to enter into the plenum system including one or more plenums; passing the ambient airflow through the one or more plenums of the plenum system by inline fans; passing the ambient airflow around or over a heat exchanger coil, thereby creating heat exchanger airflow; exiting the heat exchanger airflow from the plenum system as plenum system ambient airflow; enabling the plenum system ambient airflow to combine with a second ambient airflow in an outdoor environment to create mixed ambient airflow; and pulling the mixed ambient airflow into a cooling system, wherein the mixed ambient airflow allows for improved performance of the cooling system compared to performance of the cooling system when the ambient airflow alone is used.

Embodiment 12: The method of using the ventilation system of embodiment 11, wherein the mixed ambient airflow enters the cooling system through condenser coils of the cooling system.

Embodiment 13: The method of using the ventilation system of embodiment 11, wherein the plenum system includes a first opening and a second opening for the ambient airflow to enter the plenum system.

Embodiment 14: The method of using the ventilation system of embodiment 11, wherein the ventilation system includes a plurality of cooling systems.

Embodiment 15: The method of using the ventilation system of embodiment 11, wherein the ambient airflow is cooled by the heat exchanger coil.

Embodiment 16: The method of using the ventilation system of embodiment 11, wherein the ambient airflow is heated by the heat exchanger coil.

Embodiment 17: The method of using the ventilation system of embodiment 11, further comprising: passing the mixed ambient airflow through the cooling system to create discharged airflow; rejecting the discharged airflow from the cooling system; and recirculating the discharged airflow to become recirculated discharged airflow.

Embodiment 18: The method of using the ventilation system of embodiment 17, further comprising combining the recirculated discharged airflow into the mixed ambient airflow.

Embodiment 19: The method of using the ventilation system of embodiment 18, further comprising directing the mixed ambient airflow into the cooling system to restart a cycle of the cooling system.

Embodiment 20: The method of using the ventilation system of embodiment 11, wherein the improved performance of the cooling system using the mixed ambient airflow includes utilization of less energy than when the cooling system uses the ambient airflow alone.

Embodiment 21: A ventilation system, comprising: a cooling system, wherein the cooling system includes: a condenser, condenser coils, and a source/sink fan including an outlet configured to exit a discharged airflow; and an attachment assembly positioned at or proximate to the outlet, wherein the attachment assembly includes at least one of a straightener attachment, a venturi attachment, and a silencer attachment, and the discharged airflow passes through the attachment assembly to create a concentrated discharged airflow including at least one modified characteristic compared to the discharged airflow.

Embodiment 22: The ventilation system of embodiment 21, wherein the at least one modified characteristic includes a velocity profile, a velocity variation coefficient, a pressure distribution, and a flow direction.

Embodiment 23: The ventilation system of embodiment 22, wherein the concentrated discharged airflow includes a velocity variation coefficient of less than 0.3.

Embodiment 24: The ventilation system of embodiment 21, wherein the straightener attachment includes least one of fixed vanes, adjustable pitch vanes, a controlled orientation mechanism, a honeycomb matrix, and a rectifier grid.

Embodiment 25: The ventilation system of embodiment 24, wherein the adjustable pitch vanes and the controlled orientation mechanism are configured to make real-time airflow adjustments based on an ambient temperature, an operating mode, and/or recirculation detection.

Embodiment 26: The ventilation system of embodiment 21, wherein the attachment assembly is constructed from at least one of sheet metal, molded polymers, fiberglass, and composite materials.

Embodiment 27: The ventilation system of embodiment 21, wherein the straightener attachment includes air straightening blades configured to straighten the discharged airflow.

Embodiment 28: The ventilation system of embodiment 21, wherein the straightener attachment is configured to reduce turbulence intensity of the discharged airflow.

Embodiment 29: The ventilation system of embodiment 8, wherein the turbulence intensity is reduced by about 30% to about 80%.

Embodiment 30: The ventilation system of embodiment 21, wherein the venturi attachment includes a converging section, a throat, and a diverging section.

Embodiment 31: The ventilation system of embodiment 30, wherein the converging section includes a convergence angle from about 10 degrees to about 45 degrees.

Embodiment 32: The ventilation system of embodiment 30, wherein the throat includes a throat diameter sized from about 60% to about 95% of a diameter of the outlet.

Embodiment 33: The ventilation system of embodiment 30, wherein the diverging section includes a divergence angle from about 3 degrees to about 15 degrees.

Embodiment 34: The ventilation system of embodiment 21, wherein the venturi attachment includes at least one of annular gaps, perforations, slots, louvers, straightening vanes, aerodynamic ribs, and noise-reducing features.

Embodiment 35: The ventilation system of embodiment 21, wherein the venturi attachment is mounted above the straightener attachment.

Embodiment 36: The ventilation system of embodiment 21, wherein the straightener attachment and the venturi attachment are integrated into a single assembly.

Embodiment 37: The ventilation system of embodiment 21, wherein the ventilation system includes a plenum system, wherein the plenum system includes: a plenum, a heat exchanger coil, and one or more inline fans; wherein the one or more inline fans are operable to draw an ambient airflow into the plenum, the ambient airflow passes around or over the heat exchanger coil and undergoes a temperature change to create heat exchanger airflow, the heat exchanger airflow exits the plenum system as plenum system ambient airflow, the plenum system ambient airflow combines with a second ambient airflow in an outdoor environment to create a mixed ambient airflow, and the mixed ambient airflow enters the cooling system to allow for improved performance of the cooling system compared to performance of the cooling system when the ambient airflow alone is used.

Embodiment 38: The ventilation system of embodiment 21, further comprising a sensor system configured to measure at least one air metric of the discharged airflow, the concentrated discharged airflow, and/or an ambient airflow, and a controller configured to modulate a geometry and/or opening position of the attachment assembly based on one or more sensor measurements.

Embodiment 39: The ventilation system of embodiment 21, wherein the silencer attachment includes at least one of a honeycomb rectifier, vortex-suppressing vanes, laminarizing channels, adjustable acoustic baffles, and tunable sections.

Embodiment 40: The ventilation system of embodiment 21, wherein the straightener attachment, the venturi attachment, and the silencer attachment are integrated into a single assembly.

The construction and arrangement of the elements of the apparatus as shown in the exemplary embodiments is illustrative only. Although only a certain number of embodiments have been described in detail in this disclosure, those skilled in the art who review this disclosure will readily appreciate that many modifications are possible (e.g., variations in sizes, dimensions, structures, shapes, and proportions of the various elements, values of parameters, mounting arrangements, use of materials, colors, orientations, etc.) without materially departing from the novel teachings and advantages of the subject matter recited.

Further, elements shown as integrally formed may be constructed of multiple parts or elements shown as multiple parts may be integrally formed, the operation of the assemblies may be reversed or otherwise varied, the length or width of the structures and/or members or connectors or other elements of the system may be varied, the nature or number of adjustment or attachment positions provided between the elements may be varied. It should be noted that the elements and/or assemblies of the system may be constructed from any of a wide variety of materials that provide sufficient strength or durability. Accordingly, all such modifications are intended to be included within the scope of the present disclosure. Other substitutions, modifications, changes, and omissions may be made in the design, operating conditions, and arrangement of the exemplary embodiments without departing from the spirit of the present subject matter.

The features and functions of the various embodiments may be arranged in various combinations and permutations, and all are considered to be within the scope of the disclosed invention. Accordingly, the described embodiments are to be considered in all respects as only illustrative and not restrictive. Furthermore, the configurations, materials, and dimensions described herein are intended as illustrative and in no way limiting. Similarly, although physical explanations have been provided for explanatory purposes, there is no intent to be bound by any particular theory or mechanism, or to limit the claims in accordance therewith.

Unless otherwise defined, all technical terms used herein have the same meaning as commonly understood by one of ordinary skill in the art to which this invention belongs. It should be also understood that as used in the description herein the meaning of "a," "an," and "the" includes plural reference unless the context clearly dictates otherwise. Also, as used in the description herein, the meaning of "in" includes "in" and "on" unless the context clearly dictates otherwise. Any reference to "or" herein is intended to encompass "and/or" unless otherwise stated. As used in this specification and the claims, unless otherwise stated, the term "about," and "approximately" refers to variations of less than or equal to plus or minus 1%, 2%, 3%, 4%, 5%, 6%, 7%, 8%, 9%, 10%, 11%, 12%, 13%, 14%, or 15%, depending on the embodiment. As a non-limiting example, about 100 mm represents a range of 95 mm to 105 mm, 90 mm to 110 mm, or 85 mm to 115 mm depending on the embodiments. The term "substantially" refers to less than or equal to plus or minus 1%, 2%, 3%, 4%, 5%, 6%, 7%, 8%, 9%, 10%, 11%, 12%, 13%, 14%, or 15% variation.

Each numerical value presented herein is contemplated to represent a minimum value or a maximum value in a range for a corresponding parameter. Measurements, sizes, amounts, and the like may be presented herein in a range format. The description in range format is provided merely for convenience and brevity and should not be construed as an inflexible limitation on the scope of the invention. Accordingly, the description of a range should be considered to have specifically disclosed all the possible subranges as well as individual numerical values within that range. For example, description of a range such as 1-20 meters should be considered to have specifically disclosed subranges such as 1 meter, 2 meters, 1-2 meters, less than 2 meters, 10-11 meters, 10-12 meters, 10-13 meters, 10-14 meters, 11-12 meters, 11-13 meters, etc.

The terms and expressions employed herein are used as terms and expressions of description and not of limitation, and there is no intention, in the use of such terms and expressions, of excluding any equivalents of the features shown and described or portions thereof. In addition, having described certain embodiments of the invention, it will be apparent to those of ordinary skill in the art that other embodiments incorporating the concepts disclosed herein may be used without departing from the spirit and scope of the invention.

Although the concepts and principles of operation for the systems in FIGS. 7A-11 have been described with limited number of components for simplicity, these systems may include additional electrical and/or mechanical components necessary for their operation. Such components may include, but are not limited to, pipes, pipe connectors, pressure regulators, different types of valves, computers, electronic controllers, transformers, power supplies, electrical control panels, etc. These additional components are within the spirit and the scope of this disclosure.

Reference in the specification to "one embodiment," "preferred embodiment," "an embodiment," "some embodiments," "embodiments," or similar language (e.g., "examples"), means that a particular feature, structure, characteristic, or function described in connection with the embodiment can be included in at least one embodiment of the invention and may be in more than one embodiment. Also, the appearance of the above-noted phrases in various places in the specification is not necessarily referring to the same embodiment or embodiments.

While this specification contains many specific implementation details, these should not be construed as limitations on the scope of what may be claimed, but rather as descriptions of features that may be specific to particular embodiments. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Particular embodiments of the subject matter have been described. Other embodiments are within the scope of the following claims. For example, the actions recited in the claims can be performed in a different order and still achieve desirable results. As one example, the processes depicted in the accompanying figures do not necessarily require the particular order shown, or sequential order, to achieve desirable results. In certain implementations, multitasking and parallel processing may be advantageous. Other steps or stages may be provided, or steps or stages may be eliminated, from the described processes. Accordingly, other implementations are within the scope of the following claims.

## Claims

1. A ventilation system having a plenum system, comprising:
a cooling system, wherein the cooling system includes:
a condenser,
condenser coils, and
a source/sink fan; and
a structural base including the plenum system, wherein the plenum system includes:
a plenum,
a heat exchanger coil, and
one or more inline fans;
wherein the one or more inline fans are operable to draw an ambient airflow into the plenum,
the ambient airflow passes around or over the heat exchanger coil and undergoes a temperature change to create a heat exchanger airflow,
the heat exchanger airflow exits the plenum system as plenum system ambient airflow,
the plenum system ambient airflow combines with a second ambient airflow in an outdoor environment to create a mixed ambient airflow, and
the mixed ambient airflow enters the cooling system to allow for improved performance of the cooling system compared to performance of the cooling system when the ambient airflow alone is used.

2. The ventilation system of claim 1, wherein the mixed ambient airflow enters the cooling system by passing around or over the condenser coils.

3. The ventilation system of claim 1 or claim 2, wherein the structural base is positioned beneath the cooling system.

4. The ventilation system of any one of claims 1 to 3, wherein the plenum system spans a length of the cooling system.

5. The ventilation system of any one of claims 1 to 4, wherein the plenum includes a first end and a second end configured to draw in the ambient airflow.

6. The ventilation system of any preceding claim, wherein the ventilation system includes a plurality of cooling systems, the ventilation system optionally including a plurality of structural bases coupled to form a plenum system channel.

7. The ventilation system of any preceding claim, wherein the ambient airflow is cooled or heated by the heat exchanger coil.

8. The ventilation system of any preceding claim, wherein the improved performance of the cooling system using the mixed ambient airflow includes utilization of less energy than when the cooling system uses the ambient airflow alone.

9. A method of using a ventilation system having a plenum system, comprising:
enabling an ambient airflow to enter into the plenum system including one or more plenums;
passing the ambient airflow through the one or more plenums of the plenum system by inline fans;
passing the ambient airflow around or over a heat exchanger coil, thereby creating heat exchanger airflow;
exiting the heat exchanger airflow from the plenum system as plenum system ambient airflow;
enabling the plenum system ambient airflow to combine with a second ambient airflow in an outdoor environment to create mixed ambient airflow; and
pulling the mixed ambient airflow into a cooling system,
wherein the mixed ambient airflow allows for improved performance of the cooling system compared to performance of the cooling system when the ambient airflow alone is used.

10. The method of claim 9, wherein the mixed ambient airflow enters the cooling system through condenser coils of the cooling system.

11. The method of claim 9 or claim 10, wherein the plenum system includes a first opening and a second opening for the ambient airflow to enter the plenum system.

12. The method of any one of claims 9 to 11, wherein the ventilation system includes a plurality of cooling systems.

13. The method of any one of claims 9 to 12, further comprising:
cooling the ambient airflow by the heat exchanger coil; or
heating the ambient airflow by the heat exchanger coil.

14. The method of any one of claims 9 to 13, further comprising:
passing the mixed ambient airflow through the cooling system to create discharged airflow;
rejecting the discharged airflow from the cooling system; and
recirculating the discharged airflow to become recirculated discharged airflow,
the method optionally further comprising: combining the recirculated discharged airflow into the mixed ambient airflow, and further optionally directing the mixed ambient airflow into the cooling system to restart a cycle of the cooling system.

15. The method of any one of claims 9 to 14, further comprising: using less energy than when the cooling system uses the ambient airflow alone when using the mixed ambient airflow to provide the improved performance of the cooling system.
